# EUROPEAN PATENT APPLICATION

(11) **EP 4 318 610 A1**
(43) Date of publication of application: **07.02.2024**
(21) Application number: 22780315.2
(22) Date of filing: 22.03.2022
(51) Int. Cl.: H01L 31/18, H01L 31/05

(54) **STRING MANUFACTURING DEVICE**

(30) Priority: 31.03.2021 JP 2021060592
(71) Applicant: Panasonic Intellectual Property Management Co., Ltd., Osaka-shi, Osaka 540-6207 (JP)
(72) Inventor: INOUE, Takafumi, Osaka 571-0057 (JP); KOBAYASHI, Yukihiro, Osaka 571-0057 (JP); KAWAI, Yu, Osaka 571-0057 (JP); YAMADA, Naoya, Osaka 571-0057 (JP); YAMAMOTO, Akihiro, Osaka 571-0057 (JP)
(74) Representative: Müller-Boré & Partner Patentanwälte PartG mbB
(86) International application number: PCT/JP2022/013176
(87) International publication number: WO 2022/210100

(57) **Abstract**

A cell transporting device (50) of a string manufacturing device according to the present invention includes: a plurality of cell installation blocks disposed on a lower side of a temporary connecting member; a plurality of suction holding units (60) that are provided on both left and right direction sides of the plurality of cell installation blocks and that are pressed against a lower face of both left and right direction end portions of the temporary connecting member for suction holding of the temporary connecting member; and a transporting mechanism. The suction holding units (60) each perform suction holding of both left and right direction end portions of the temporary connecting member, and then move in an upper direction and to a forward side in a direction of advance, and thereafter move in a downward direction, thereby transporting the temporary connecting member from the cell installation blocks to cell installation blocks at the forward side in the direction of advance, and suction is stopped, and thereafter return to a rearward side in the direction of advance, which operation is repeatedly performed, thereby transporting the temporary connecting member to the forward side in the direction of advance.

## Description

### TECHNICAL FIELD

The present invention relates to a manufacturing device for a string configured by connecting a plurality of solar cells via a wiring member.

### BACKGROUND

A solar cell module is configured by arranging a plurality of strings, in which a plurality of solar cells are connected by a wiring member, side by side, electrically connecting the strings in series with each other, and sandwiching the strings between glass, a back surface material, and a sealing material. The wiring member is bonded onto an electrode of the solar cell, and solder is mainly used for the bonding. However, warpage or cracking of the solar cell may occur due to thermal effects during soldering. Such a problem appears more conspicuously as the thickness of the solar cell decreases. For this reason, a method of bonding a wiring member and a solar cell using a resin adhesive (hereinafter, simply referred to as an "adhesive") instead of solder is proposed (see, for example, Patent Literature 1).

### CITATION LIST

### PATENT LITERATURE

Patent Literature 1: WO 2014/132575 A

### SUMMARY

### TECHNICAL PROBLEM

When a string is formed by bonding a wiring member to a plurality of solar cells with an adhesive, a temporary connection body in which the plurality of solar cells are temporarily connected in a band shape is formed by temporarily bonding the plurality of solar cells with a wiring member, and then the wiring member is thermocompression-bonded to the solar cells by a thermocompression bonding device to form a string. At this time, when the temporary connection body is conveyed to the thermocompression bonding device by using a plurality of holding units that suck and hold the solar cell, if the number of wiring members for each solar cell is large, the holding unit cannot be brought into contact with an inner portion that largely enters the inner side from the outer periphery of the solar cell. In addition, in the temporary connection body, since the bonding strength between the wiring member and the solar cell is weak, a large load cannot be applied to the wiring member at the time of conveyance, and the conveyance work is difficult. In addition, the temporary connection body needs to be conveyed with high accuracy and straightness so that the wiring member does not deviate from the bonding region in the left-right direction.

### SOLUTION TO PROBLEM

A string manufacturing device according to the present invention is a string manufacturing device for manufacturing a string by connecting a plurality of solar cells with collecting electrodes arranged side by side on a light-receiving surface and a back surface through a wiring member, the string manufacturing device comprising
a cell conveyance device that conveys a temporary connection body of the plurality of solar cells temporarily connected in a band shape by temporarily bonding the wiring member, in which the cell conveyance device includes: a plurality of cell installation bases arranged on a lower side of the temporary connection body along a traveling direction of the temporary connection body; a plurality of suction holding units that are provided on both sides in a left-right direction orthogonal to the traveling direction of each of the plurality of cell installation bases, are pressed against lower surfaces of both end portions of the temporary connection body in the left-right direction, and suck and hold both end portions of the temporary connection body in the left-right direction by sucking outside air to a lower side; and a moving mechanism that moves the plurality of suction holding units to both sides in a vertical direction and the traveling direction, and each of the plurality of suction holding units repeats an operation of sucking and holding both end portions of the temporary connection body in the left-right direction, moving upward and to the front side in the traveling direction, then moving downward to move the temporary connection body from the cell installation base to the cell installation base on the front side in the traveling direction, stopping suction, and returning to the rear side in the traveling direction, thereby moving the temporary connection body to the front side in the traveling direction.

### ADVANTAGEOUS EFFECTS OF INVENTION

According to the present invention, each of the plurality of suction holding units repeats the operation of sucking and holding both end portions of the temporary connection body in the left-right direction, moving in the upward direction and to the front side in the traveling direction, then then moving in the downward direction to move the temporary connection body from the cell installation base to the cell installation base on the front side in the traveling direction, stopping suction, and returning to the rear side in the traveling direction, thereby moving the temporary connection body to the front side in the traveling direction. As a result, even in a case where the holding unit cannot be brought into contact with an inner portion that is very deep inside from the outer periphery of the solar cell due to the large number of wiring members for each solar cell, the temporary connection body can be conveyed while preventing contact with the wiring member by bringing the holding unit into contact with both end portions of the solar cell in the left-right direction. In addition, since the temporary connection body can be conveyed while maintaining a change in the distance between the solar cells, it is possible to prevent a large load from being applied to the wiring member. Further, the temporary connection body can be conveyed with high accuracy and straightness so that the wiring member does not deviate from the bonding region in the left-right direction.

### BRIEF DESCRIPTION OF DRAWINGS

FIG. 1 is a cross-sectional view of a solar cell module including a string obtained by a string manufacturing device according to an example of an embodiment of the present invention.
FIG. 2 is a view (front view) of a solar cell configuring the string of FIG. 1 as viewed from the light-receiving surface side.
FIG. 3 is a view (rear view) of the solar cell configuring the string of FIG. 1 as viewed from the back surface side.
FIG. 4 is a flowchart illustrating a method of manufacturing a string using the string manufacturing device which is an example of the embodiment of the present invention.
FIG. 5 is a perspective view illustrating a string manufacturing device which is an example of the embodiment of the present invention.
FIG. 6 is a perspective view illustrating a cutting device and a temporary crimping device in the string manufacturing device of FIG. 4.
FIG. 7 is a schematic view illustrating a state in which a wiring member cut and drawn by the cutting device is drawn out to the temporary crimping device.
FIG. 8 is an enlarged perspective view illustrating a feed chuck portion in FIG. 6.
FIG. 9 is a perspective view illustrating a state in which an upper chuck of the feed chuck portion of FIG. 6 is brought close to the distal end of a lower chuck.
FIG. 10 is an enlarged perspective view of the upper chuck of FIG. 8 as viewed from below.
FIG. 11 is an enlarged perspective view illustrating a positional deviation prevention guide fixed to the lower chuck.
FIG. 12 is a view corresponding to FIG. 8, illustrating a state in which the wiring member is held by the feed chuck portion.
FIG. 13 is a perspective view as viewed from the top of FIG. 12 without an upper chuck.
FIG. 14 is an enlarged perspective view illustrating a restriction chuck portion in FIG. 6.
FIG. 15 is a schematic view illustrating a step of drawing out the wiring member of a first type cut and drawn by the cutting device to the temporary crimping device.
FIG. 16 is a schematic view illustrating a step of drawing out the wiring member of a second type cut and drawn by the cutting device to the temporary crimping device.
FIG. 17A is a schematic view illustrating a step of drawing out and cutting a wiring member and then temporarily crimping the wiring member to a solar cell in a string manufacturing device of a comparative example.
FIG. 17B is an enlarged view of a portion A in FIG. 2.
FIG. 18 is a schematic perspective view illustrating an upper stage for configuring the temporary crimping device of FIG. 6.
FIG. 19 is a schematic perspective view illustrating a lower stage for configuring the temporary crimping device of FIG. 6 as viewed from the above.
FIG. 20 is a schematic perspective view illustrating the lower stage of FIG. 19 as viewed from below.
FIG. 21 is a schematic enlarged perspective view illustrating a lower plate for configuring the lower stage of FIG. 19 as viewed obliquely from above.
FIG. 22 is a schematic perspective view illustrating the lower plate of FIG. 19 as viewed obliquely from below.
FIG. 23 is a view illustrating the lower plate of FIG. 21 as viewed from the above.
FIG. 24 is an enlarged view of a portion B in FIG. 23.
FIG. 25 is a schematic perspective view illustrating the upper portion of the lower plate in FIG. 21 as viewed from one end side in the longitudinal direction of a suction groove.
FIG. 26 is an enlarged view illustrating a cross section of the lower plate at a suction hole position in a state where the wiring member is sucked and held in the suction groove.
FIG. 27 is a view illustrating a state where the wiring member is arranged in one suction groove in FIG. 25 as viewed from one side in the longitudinal direction.
FIG. 28 is a partially enlarged cross-sectional view illustrating a state in which a wiring member and a solar cell are sandwiched between the upper plate and the lower plate during temporary crimping.
FIG. 29 is a schematic view illustrating a preferable relationship between the suction groove and the suction hole.
FIG. 30(a) is a diagram illustrating a case where a groove width has a maximum value including machining intersection, and FIG. 30(b) is a diagram illustrating a case where the groove width has a minimum value including machining intersection, with respect to a dimensional relationship between the suction groove and the wiring member.
FIG. 31 is a perspective view illustrating a part of the upper plate of FIG. 18 in a cut manner.
FIG. 32 is a cross-sectional view illustrating a first example of a shape in which an air collection passage and the suction groove are communicated with each other via the suction hole in the upper plate of FIG. 31.
FIG. 33 is a cross-sectional view illustrating a second example of a shape in which the air collection passage and the suction groove are communicated with each other via the suction hole in the upper plate of FIG. 31.
FIG. 34 is a cross-sectional view illustrating a third example of a shape in which the air collection passage and the suction groove are communicated with each other via the suction hole in the upper plate of FIG. 31.
FIG. 35 is a schematic view illustrating a step of causing suction leakage in a gap between the suction groove and the wiring member to fix the solar cell between the wiring members in a case where the wiring member is temporarily crimped to the solar cell after the wiring member is held on the upper plate and the lower plate of the temporary crimping device of FIG. 6.
FIG. 36 is a schematic view illustrating a state in which the suction grooves of the upper plate and the lower plate of the temporary crimping device in FIG. 6 are aligned.
FIG. 37 is a perspective view illustrating a cell conveyance device in the string manufacturing device of FIG. 4.
FIG. 38 is an enlarged view of a portion D in FIG. 37.
FIG. 39 is an enlarged view of a portion E in FIG. 38.
FIG. 40 illustrates a state in which a temporary connection body of a solar cell is conveyed in a cell conveyance device of a comparative example, in which (a) is a view illustrating a conveyance unit of one solar cell as viewed from above, and (b) is a view illustrating the cell conveyance device as viewed in a left-right direction.
FIG. 41 is a schematic view illustrating a suction allowable range of the solar cell in the embodiment.
FIG. 42 is a schematic view illustrating an allowable deviation width in a case where one solar cell is deviated in the left-right direction during conveyance in the temporary connection body of solar cells.
FIG. 43 is a schematic view illustrating an operation when the solar cell is conveyed by using the cell conveyance device in the embodiment.
FIG. 44 is a schematic view illustrating an effect obtained by forming a relief groove on the upper surface of a cell installation base of the conveyance device in the embodiment.
FIG. 45 is a schematic view illustrating inconvenience when there is no relief groove on the upper surface of the cell installation base of the conveyance device in another example of the embodiment.
FIG. 46(a) is a schematic view illustrating a state in which the temporary connection body is crimped by a main crimping device in the embodiment, and FIG. 46(b) is a view illustrating a temporal change in a temperature (cell temperature) of a front end portion of the temporary connection body and a linear pressure applied to the front end portion of the temporary connection body when the temporary connection body is caused to pass through the main crimping device in FIG. 46(a).
FIG. 47 is a perspective view illustrating the main crimping device and the temporary connection body of FIG. 46(a) as viewed from above.
FIGS. 48(a) and 48(b) are schematic views illustrating an operation when the temporary connection body is caused to pass through the main crimping device of the embodiment, and FIG. 48(c) is a view illustrating a temporal change in the linear pressure applied to the front end portion of the temporary connection body when the temporary connection body is caused to pass through the main crimping device.
FIG. 49(a) is a side view illustrating a main crimping device configuring a string manufacturing device of a first example of the comparative example, and FIG. 49(b) is a schematic view illustrating a state in which a change in a position of the temporary connection body when the temporary connection body is moved while being crimped by the main crimping device is viewed from above.
FIG. 50 is a schematic view illustrating a state in which a linear pressure is non-uniformly applied to one solar cell in the main crimping device configuring the string manufacturing device of a second example of the comparative example.
FIG. 51 is a schematic view illustrating an operation when the temporary connection body and a dummy plate are caused to pass through the main crimping device according to the embodiment.
FIG. 52 is a schematic view illustrating that a variable pressure mechanism is provided in each pressing stage of the main crimping device to increase the pressing force of the variable pressure mechanism when the temporary connection body enters into the pressing stage in another example of the embodiment.
FIG. 53 is a schematic view illustrating that a self-weight canceling mechanism is provided in an upper unit of the main crimping device in another example of the embodiment.

### DESCRIPTION OF EMBODIMENTS

Hereinafter, embodiments according to the present invention will be described in detail with reference to the drawings. The drawings referred to in the embodiments are schematically illustrated, and dimensional ratios and the like of components shown in the drawings may be different from actual ones. Specific dimensional ratios and the like should be determined in consideration of the following description.

In the present specification, the "light-receiving surface" means a surface on which sunlight is mainly incident from the outside of a solar cell. The "back surface" means a surface opposite to the light-receiving surface. More specifically, greater than 50% and less than or equal to 100% of sunlight incident on the solar cell is incident from the light-receiving surface side. In addition, "above" means vertically above unless otherwise specified. In addition, "substantially **" is intended to include not only completely the same but also substantially the same when "substantially the same" is described as an example.

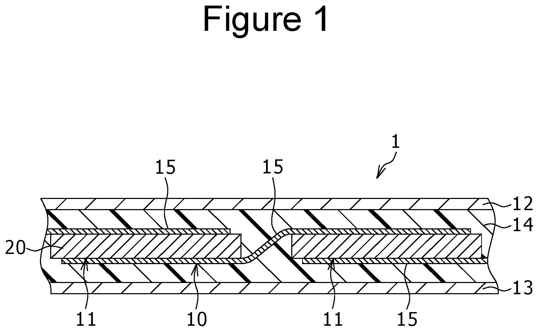

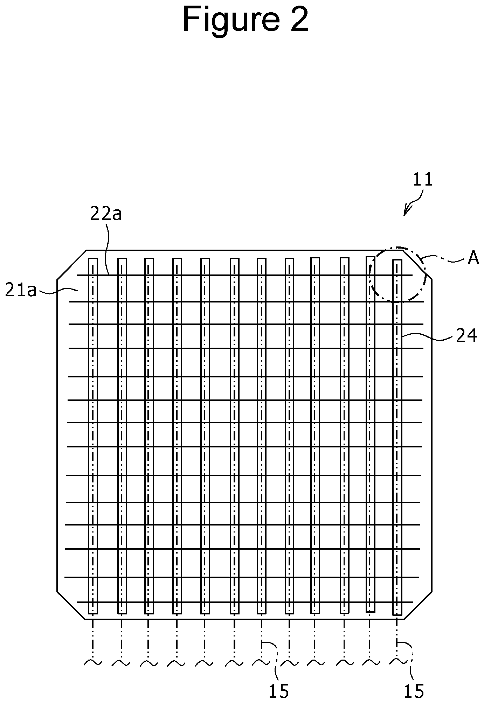

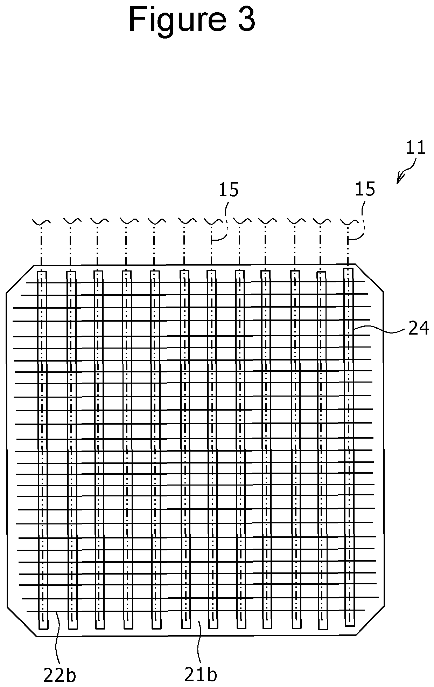

FIG. 1 is a cross-sectional view of a solar cell module 1 including a string 10 obtained by a string manufacturing device according to an example of an embodiment of the present invention. FIGS. 2 and 3 are views illustrating solar cells 11 configuring the string 10 as viewed from the light-receiving surface side and the back surface side, respectively (a wiring member 15 is indicated by a two-dot chain line). Hereinafter, the string 10 described with reference to FIGS. 1 to 3 is an example of a product manufactured by a manufacturing device described below. In the following description, a case where bus bar electrodes are not arranged on both side surfaces of the solar cell 11 is described, but the bus bar electrodes may be arranged on both side surfaces of the solar cell 11 so as to intersect finger electrodes 22a and 22b at substantially right angles. The bus bar electrode is an electrode that collects carriers from the finger electrodes 22a and 22b. In that case, an adhesive for fixing the wiring member 15 described below to the solar cell 11 is applied to a portion where the bus bar electrodes are arranged on both side surfaces of the solar cell 11, so that the wiring member 15 may be fixed to the bus bar electrodes.

As illustrated in FIG. 1, the solar cell module 1 includes a plurality of strings 10 arranged in a plurality of rows in the lateral direction and electrically connected to each other in series. The string 10 is formed in a band shape by connecting the plurality of solar cells in which collecting electrodes are arranged side by side on the light-receiving surface and the back surface via the wiring member 15.

A first protection member 12 is arranged on the light-receiving surface side of the solar cell 11, and a second protection member 13 is arranged on the back surface side of the solar cell 11. The plurality of solar cells 11 are sandwiched between the protection members 12 and 13 and sealed with a sealing material 14 such as an ethylene-vinyl acetate copolymer (EVA). As the protection members 12 and 13, for example, a translucent member such as a glass substrate, a resin substrate, or a resin film can be used. When it is not assumed that light is incident from the back surface side, a member having no translucency may be used for the protection member 13. The solar cell module 1 further includes a frame, a terminal box, and the like (not illustrated).

The solar cell 11 includes a photoelectric conversion unit 20 that generates a carrier by receiving the sunlight. The photoelectric conversion unit 20 includes, for example, a semiconductor substrate such as crystalline silicon (c-Si), gallium arsenide (GaAs), or indium phosphide (InP), and an amorphous semiconductor layer formed on the substrate. The photoelectric conversion unit 20 preferably includes transparent conductive layers 21a and 21b formed on the amorphous semiconductor layer. Specific examples include a structure in which an i-type amorphous silicon layer, a p-type amorphous silicon layer, and the transparent conductive layer 21a are sequentially formed on the light-receiving surface of an n-type single-crystalline silicon substrate, and an i-type amorphous silicon layer, an n-type amorphous silicon layer, and the transparent conductive layer 21b are sequentially formed on the back surface. The transparent conductive layers 21a and 21b are preferably made of transparent conductive oxide obtained by doping metal oxide such as indium oxide (In₂O₃) or zinc oxide (ZnO) with tin (Sn), antimony (Sb), or the like.

As illustrated in FIGS. 2 and 3, it is preferable to provide the finger electrode 22a as a collecting electrode on the light-receiving surface side and the finger electrode 22b as a collecting electrode on the back surface side on the photoelectric conversion unit 20. The finger electrodes 22a and 22b are thin line-shaped electrodes formed over a wide range on the transparent conductive layers 21a and 21b, respectively.

In the present embodiment, a large number of the finger electrodes 22a and 22b formed linearly are arranged at predetermined intervals. The collecting electrode on the back surface side also has the same electrode arrangement as that of the collecting electrode on the light-receiving surface side, but the collecting electrode on the back surface side can be formed to have a larger area than that of the collecting electrode on the light-receiving surface side because the influence of the light shielding loss on the photoelectric conversion characteristic is smaller on the back surface than on the light-receiving surface. The collecting electrode on the back surface side has, for example, an electrode area greater than or equal to about twice, and less than or equal to about six times, an electrode area of the collecting electrode on the light-receiving surface side, and the number of finger electrodes 22b can be increased more than the number of finger electrodes 22a. That is, it can be said that the "light-receiving surface" is a surface having a smaller electrode area, and the "back surface" is a surface having a larger electrode area.

The collecting electrode has, for example, a structure in which a conductive sealing material such as silver (Ag) is dispersed in a binder resin. The collecting electrode having this structure can be formed by, for example, screen printing.

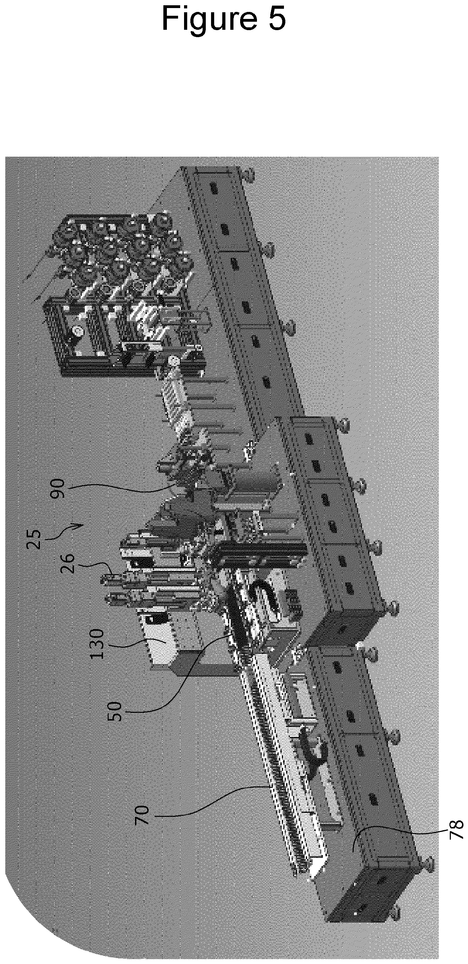

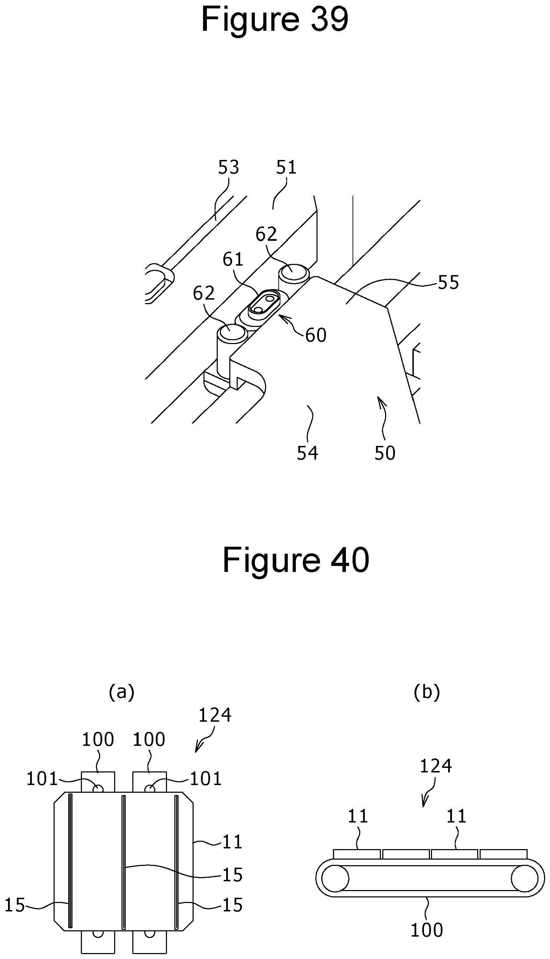

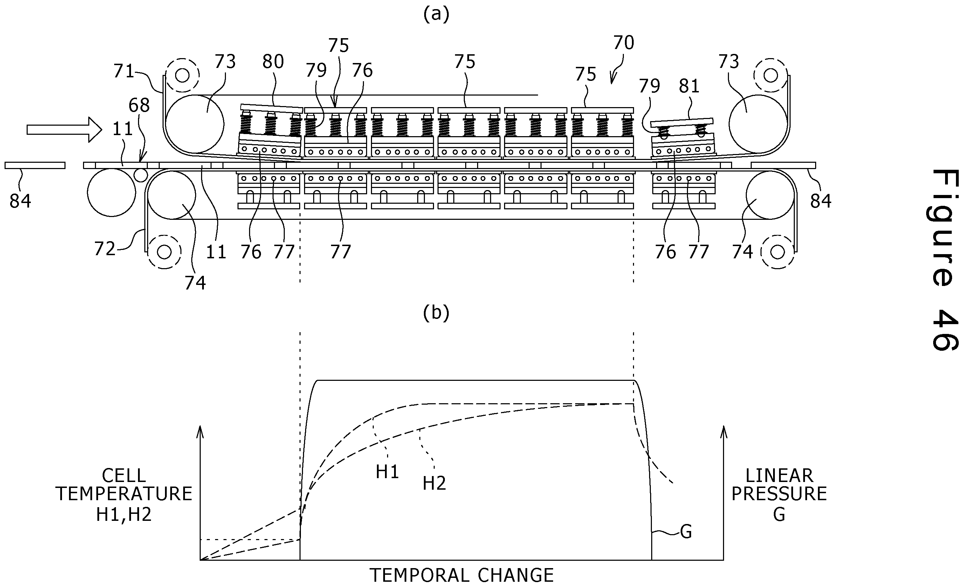

The wiring member 15 is an elongated member that connects the solar cells 11 arranged adjacent to each other. The wiring member 15 has a substantially circular cross section. The wiring member 15 may have a substantially rectangular cross section. Meanwhile, it is preferable that the wiring member 15 has a substantially circular cross section from the viewpoint of reducing the portion shaded by the wiring member 15 on the surface of the solar cell 11 to increase the output of the solar cell module 1. Furthermore, in a case where the cross section of the wiring member 15 is substantially circular, it is possible to extract a large current with low resistance from the solar cells by connecting a large number of 10 or more solar cells arranged adjacent to each other. FIGS. 2 and 3 illustrate a case where the solar cells 11 arranged adjacent to each other are connected by 12 wiring members 15. Meanwhile, when a large number of the wiring members 15 are used, the pitch of the wiring members 15 is narrowed, and thus it is difficult to employ a belt conveyor system in which suction holes 101 provided in a belt 100 are arranged between the wiring members 15 and the solar cells 11 are sucked and conveyed using the suction holes 101 as in a comparative example illustrated in FIG. 40 described below. Furthermore, when a temporary connection body obtained by temporarily connecting the plurality of solar cells 11 that are temporarily crimped with an adhesive with the wiring member 15 is conveyed by a conveyance device, it is necessary to maintain a constant distance between the solar cells 11 so that a large load is not applied to the wiring member 15. In addition, it is necessary to reduce an allowable width of the misalignment of the string 10 at the time of conveyance in the left-right direction, for example, to set the allowable deviation width to 1 mm to increase the straightness. For this reason, in the embodiment, as described below, a cell conveyance device 50 (FIG. 5) that can convey the solar cells 11 adjacent to each other in a temporary connection body 68 (FIG. 46) while a constant distance therebetween is maintained is employed. The cell conveyance device 50 employs a pole feeding conveyance system in which both end portions of the solar cells 11 in the left-right direction orthogonal to the traveling direction are held by suction holding units and conveyed. Hereinafter, a case where the wiring member 15 has a substantially circular cross section will mainly be described.

One end side of the wiring member 15 is attached to the light-receiving surface side of one solar cell 11 out of the solar cells 11 arranged adjacent to each other by an adhesive 24. The other end side of the wiring member 15 is attached to the back surface side of the other solar cell 11 with the adhesive 24. That is, the wiring member 15 is bent in the thickness direction of the solar cell module 1 between the solar cells 11 arranged adjacent to each other and connects the solar cells 11 in series. The wiring member 15 is bonded to cross and to be in contact with the plurality of finger electrodes 22a and 22b of the solar cells 11 arranged adjacent to each other.

As the adhesive 24, a thermoplastic adhesive, a thermosetting adhesive, a normal temperature curing adhesive (moisture curing type or two-liquid curing type), or an energy ray curing adhesive (ultraviolet curing type) can be used. Among these, a curable adhesive is preferable, and a thermosetting adhesive is particularly preferable. Examples of the thermosetting adhesive include a urea-based adhesive, a resorcinol-based adhesive, a melamine-based adhesive, a phenol-based adhesive, an epoxy-based adhesive, a polyurethane-based adhesive, a polyester-based adhesive, a polyimide-based adhesive, and an acryl-based adhesive.

The adhesive 24 may contain a conductive sealing material such as Ag particles, but a non-conductive thermosetting adhesive that does not contain a conductive sealing material is preferably used from the viewpoint of manufacturing cost, light shielding loss reduction, and the like. The adhesive 24 before curing is in a liquid state. The term "liquid state" is intended to include a state having fluidity at normal temperature (25°C) and a state called a paste state. The viscosity of the adhesive 24 is about greater than or equal to 1 Pa s and less than or equal to 50 Pa s.

The adhesive 24 is preferably applied so as to exist only between the wiring member 15 and the light-receiving surface and between the wiring member 15 and the back surface. That is, the adhesive 24 is preferably applied with a width that does not protrude from between the wiring member 15 and the light-receiving surface and between the wiring member 15 and the back surface.

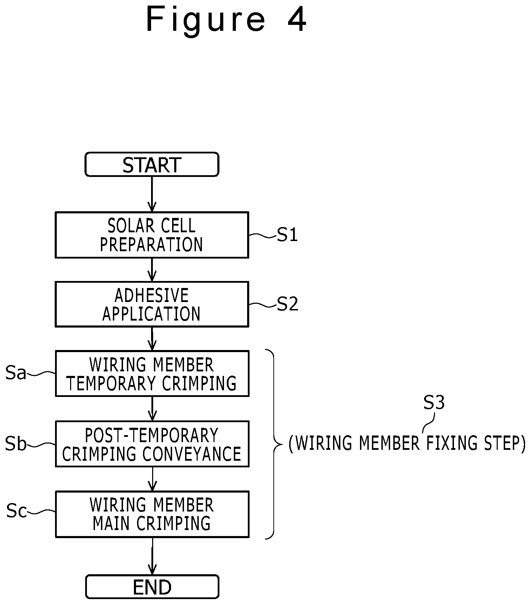

Hereinafter, a manufacturing device of the string 10, which is an example of the embodiment of the present invention, will be described in detail with reference to the drawings. FIG. 4 is a flowchart illustrating a method of manufacturing the string 10 of the embodiment.

As illustrated in FIG. 4, the manufacturing method of the embodiment includes a solar cell preparation step S1, an adhesive application step S2, and a wiring member fixing step S3. The solar cell preparation step S1 is a step of preparing a plurality of solar cells 11 forming the string 10. As illustrated in FIGS. 2 and 3, in each of the plurality of solar cells 11, the finger electrodes 22a and 22b as collecting electrodes are arranged side by side on the light-receiving surface and the back surface. At this time, in each of the plurality of solar cells 11, bus bar electrodes as other collecting electrodes may be arranged side by side on the light-receiving surface and the back surface so as to cross the finger electrodes 22a and 22b. At this time, the bus bar electrodes are arranged outside the finger electrodes 22a and 22b.

In the adhesive application step S2, the adhesive 24 (FIGS. 2 and 3) is applied to the light-receiving surface and the back surface of the solar cell 11 in a plurality of rows in the lateral direction along the wiring member arrangement position.

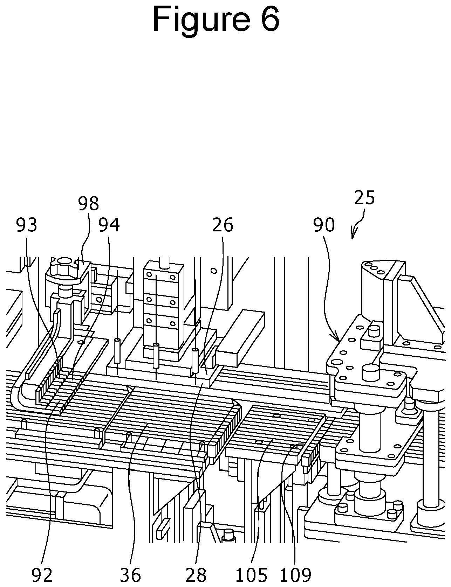

The wiring member fixing step S3 includes a wiring member temporary crimping step Sa, a post-temporary crimping conveyance step Sb, and a wiring member main crimping step Sc. In the wiring member temporary crimping step, the plurality of wiring members 15 are simultaneously drawn out from a plurality of wiring member winding portions where the wiring members 15 are wound around the bobbin and cut to a predetermined length to form first wiring members, the plurality of first wiring members are adsorbed and held on a lower stage 36 (FIG. 6) of a temporary crimping device 26 (FIGS. 5 and 6) by suction of outside air, and then the solar cells 11 are arranged on the plurality of first wiring members. Thereafter, in the wiring member temporary crimping step, similarly to the first wiring member, the plurality of second wiring members that are cut into a predetermined length are sucked and held on an upper stage 28 (FIG. 6) of the temporary crimping device 26 by suction of outside air. Then, by pressing the plurality of second wiring members against the upper side of the solar cell 11, the plurality of wiring members 15 are temporarily crimped to the light-receiving surface and the back surface of the solar cell, respectively. At this time, the solar cells 11 are heated and pressed by the upper stage 28 and the lower stage 36 via the wiring member 15.

Thereafter, in the wiring member temporary crimping step, the wiring member 15 and the solar cell 11 that are temporarily crimped are moved, and the adjacent solar cells 11 are arranged on the upper side of the portion of the first wiring member extending from the solar cell 11. Then, the plurality of first wiring members sucked and held by suction of outside air are pressed against the upper stage 28 on the adjacent solar cells 11. Also at this time, the solar cells 11 are heated and pressed by the upper stage 28 and the lower stage 36 via the wiring member 15. Thus, the adjacent solar cells 11 are temporarily bonded by the plurality of wiring members 15, and this temporary bonding is repeated to form a temporary connection body 68 (FIG. 46) in which the plurality of solar cells 11 is temporarily connected via the wiring members 15.

In the post-temporary crimping conveyance step, the temporary connection body 68 is moved from the temporary crimping device 26 to the main crimping device 70 (FIG. 5) that performs the wiring member main crimping step by using the cell conveyance device 50 (FIG. 5).

In the wiring member main crimping step, the temporary connection body 68 is heated and pressed by the main crimping device 70 to cure the adhesive, and thus the string 10 in which the plurality of solar cells 11 are bonded via the wiring member 15 is formed.

The string 10 can be manufactured by a string manufacturing device 25 (FIG. 5) of the embodiment. The string manufacturing device 25 is a system configuring a portion of a manufacturing line of the solar cell module 1 and manufactures the string 10 in which the plurality of solar cells 11 are connected by the wiring member 15 by attaching the wiring member 15 to the solar cells 11 to which the adhesive 24 is applied. The string 10 is conveyed to, for example, a laminating device (not illustrated), and the solar cell module 1 is manufactured in a laminating step.

FIG. 5 is a perspective view illustrating the string manufacturing device 25. The string manufacturing device 25 includes a cutting device 90, the temporary crimping device 26, the cell conveyance device 50, and the main crimping device 70. FIG. 6 illustrates the cutting device 90 and the temporary crimping device 26 in the string manufacturing device 25. The cutting device 90 simultaneously draws out the plurality of wiring members 15 from the plurality of wiring member winding portions and cuts the plurality of wiring members into a predetermined length to form the plurality of first wiring members or the plurality of second wiring members.

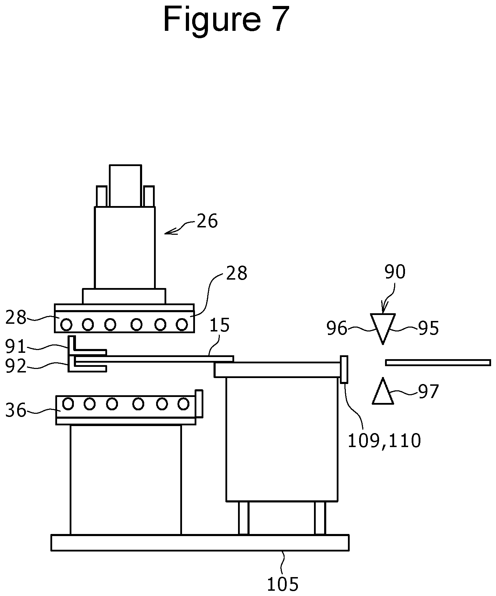

FIG. 7 is a schematic view illustrating a state in which the wiring member 15 cut and drawn by the cutting device 90 is drawn out to the temporary crimping device 26. The cutting device 90 includes a drawing out mechanism 91 that draws out the plurality of wiring members 15 and a cutting main body device 95. The drawing out mechanism 91 includes a feed chuck portion 92 and a chuck moving mechanism 98 (FIG. 6) that moves the feed chuck portion.

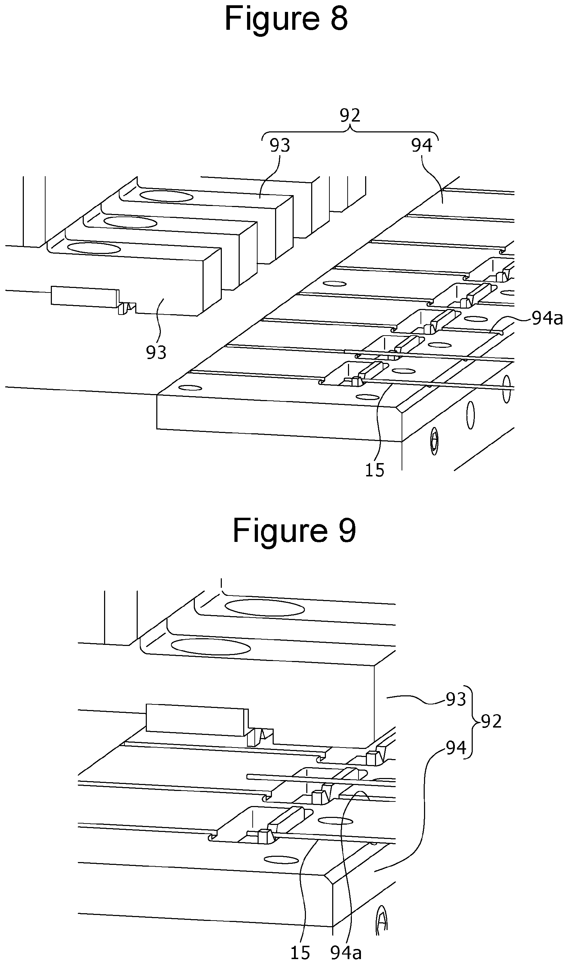

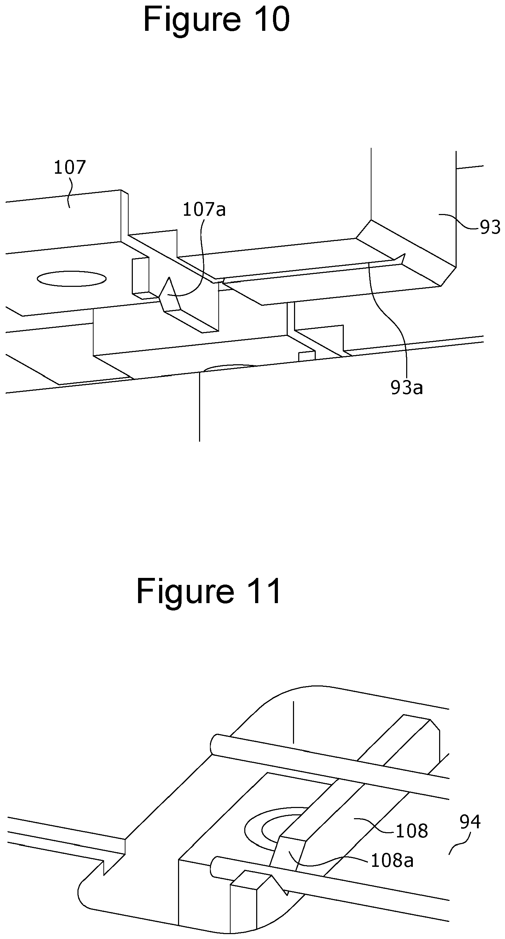

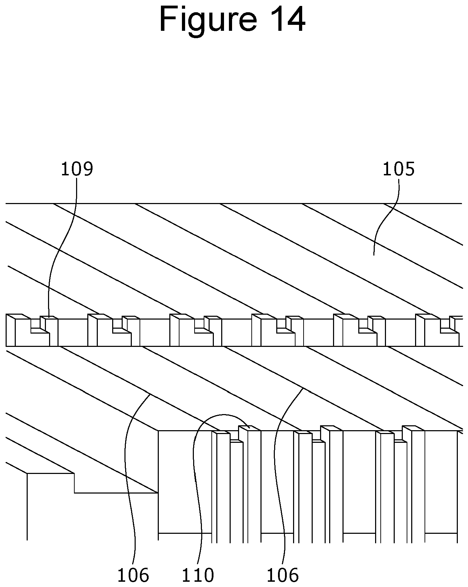

FIG. 8 is an enlarged perspective view illustrating the feed chuck portion 92 in FIG. 6. FIG. 9 is a perspective view illustrating a state in which an upper chuck 93 of the feed chuck portion 92 of FIG. 6 is brought close to the distal end of a lower chuck 94. FIG. 10 is an enlarged perspective view of the upper chuck 93 of FIG. 8 as viewed from below. In the feed chuck portion 92, the upper chuck 93 and the lower chuck 94 capable of relatively moving on the lower side thereof can cooperate to switch between gripping and releasing of the end portions of the plurality of wiring members 15. The operation of the feed chuck portion 92 is controlled by a control device (not illustrated). A plurality of V-shaped grooves 93a and 94a are formed in the lower surface of the upper chuck 93 and the upper surface of the lower chuck 94, respectively. The wiring member 15 having a circular cross section is gripped so as to be vertically sandwiched between the groove 93a of the upper chuck 93 and the groove 94a of the lower chuck 94. As a result, the wiring member 15 automatically moves to the center of the V-shape of the grooves 93a and 94a. In this state, the chuck moving mechanism 98 moves the feed chuck portion 92 in the horizontal direction so as to draw out the plurality of wiring members 15. At that time, the feed chuck portion 92 allows the plurality of wiring members 15 to pass through the upper surface of a backup stage 105 while allowing the plurality of wiring members 15 to pass between a plurality of upper teeth 96 arranged side by side in the lateral direction of the cutting main body device 95 and a plurality of lower teeth 97 on the lower side thereof. Thereafter, the feed chuck portion 92 moves the plurality of wiring members 15 between the upper stage 28 and the lower stage 36 of the temporary crimping device 26. A plurality of grooves 106 (FIG. 14) are formed on the upper surface of the backup stage 105 in the longitudinal direction of the wiring member 15 in accordance with the plurality of wiring members 15. Suction holes (not illustrated) are formed in the bottom portions of the plurality of grooves 106, and a first suction device (not illustrated) is connected to the suction holes through a flow path inside the backup stage 105. The first suction device is a mechanism that sucks outside air from the suction hole, and uses a vacuum pump that is an air discharge unit. As a result, the backup stage 105 sucks and holds the wiring member 15 arranged in the groove 106 on the upper surface by sucking outside air through the suction hole. As a result, when the wiring member 15 is placed on the upper surface of the backup stage 105 and then cut by the cutting main body device 95, it is possible to prevent the wiring member 15 from being disassembled and becoming impossible to hold.

The chuck moving mechanism 98 can switch between a state in which the upper chuck 93 is separated from the distal end of the lower chuck 94 in the horizontal direction as illustrated in FIG. 8 and a state in which the upper chuck 93 substantially coincides with the distal end of the lower chuck 94 in the longitudinal direction of the wiring member 15 as illustrated in FIG. 9.

FIG. 11 is an enlarged perspective view illustrating a positional deviation prevention guide 108 fixed to the lower chuck 94. As illustrated in FIGS. 10 and 11, in each of the upper chuck 93 and the lower chuck 94, positional deviation prevention guides 107 and 108 are fixed at a position separated from the grooves 93a and 94a (FIG. 9) in the longitudinal direction of the wiring member 15. V-shaped guide grooves 107a and 108a are formed in the positional deviation prevention guides 107 and 108. The depths of the guide grooves 107a and 108a are larger than the depths of the grooves 93a and 94a and larger than the diameter of the wiring member 15.

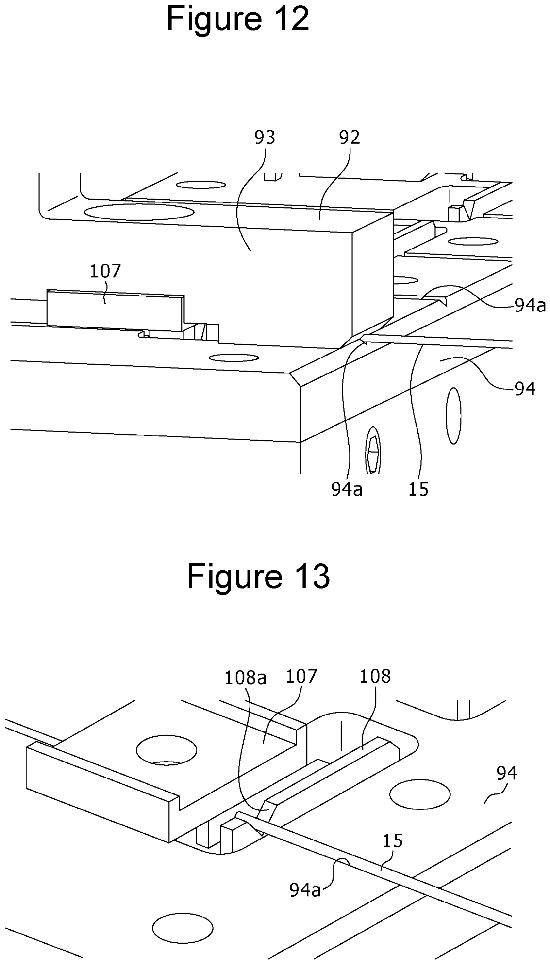

FIG. 12 is a view corresponding to FIG. 8, illustrating a state in which the wiring member 15 is held by the feed chuck portion 92. FIG. 13 is a perspective view as viewed from the top of FIG. 12 without the upper chuck 93. In a state where the wiring member 15 is held in the groove 94a on the upper surface of the lower chuck 94, the upper chuck 93 is lowered as illustrated in FIG. 12, and the wiring member 15 is sandwiched between the grooves 93a and 94a of the upper chuck 93 and the lower chuck 94. In this state, the lower surface of the upper chuck 93 is pressed against the upper surface of the lower chuck 94. At this time, as illustrated in FIG. 13, sandwiching of the wiring member 15 in a state where the positions of the guide groove 108a on the lower chuck 94 side and the guide groove 107a on the upper chuck 93 side (FIG. 10) are deviated in the longitudinal direction of the wiring member 15 prevents positional deviation in the left-right direction orthogonal to the longitudinal direction of the wiring member 15.

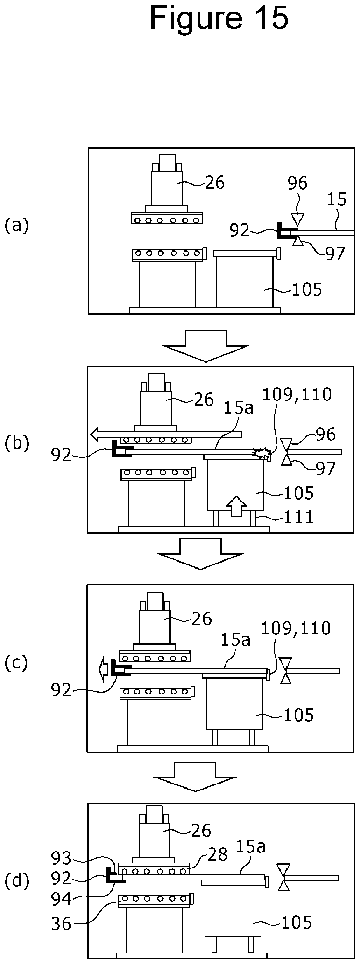

FIG. 14 is an enlarged perspective view illustrating restriction chuck portions 109 and 110 in FIG. 6. The backup stage 105 is arranged in the vicinity of the cutting device 90 (FIG. 6). As illustrated in FIG. 15 described below, the backup stage 105 is provided with extendable and contractible leg portions 111 at a lower portion, and the upper surface is movable in the vertical direction by extension and contraction of the leg portions 111. The leg portion 111 can be expanded and contracted by, for example, a cylinder device such as a pneumatic cylinder device or a hydraulic cylinder device, and the operation thereof is controlled by the control device. Two sets of the restriction chuck portions 109 and 110 having two sandwiching portions at positions sandwiching the groove 106 in the left-right direction in each set are provided on the upper surface of the backup stage 105 at an end on the cutting device 90 side and at a position slightly inward from the end. One of the two sandwiching portions moves in the left-right direction with respect to the other. In each of the plurality of restriction chuck portions 109 and 110 at the same position in the longitudinal direction of the groove 106, one sandwiching portion may be provided in an integrated member, and these sandwiching portions may move simultaneously with one another in an interlocking manner. The operation of one sandwiching portion is controlled by the control device. The restriction chuck portions 109 and 110 are used to grip an end portion of the wiring member 15 on the cutting device 90 side gripped and pulled out by the feed chuck portion 92 as described below, cut the wiring member 15 with the cutting device 90, and then further pull the wiring member 15 with the feed chuck portion 92. As a result, it is possible to alleviate the tendency to bend in the winding direction caused by the wiring member 15 being wound around the bobbin. In the cutting main body device 95 of the cutting device 90, the plurality of upper teeth 96 and the plurality of lower teeth 97 are relatively moved in the vertical direction. The wiring member 15 is cut by the approach of the upper teeth 96 and the lower teeth 97. The operation of the cutting main body device 95 is controlled by the control device.

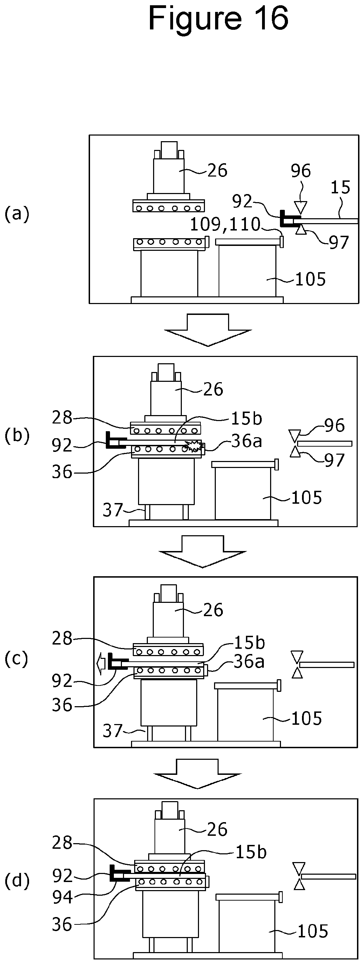

A method of drawing out the wiring member 15 is described with reference to FIGS. 15 and 16. The wiring member 15 includes the wiring member 15a of a first type that is the long wiring member 15 configuring the string 10 and connecting the two adjacent solar cells 11 and the wiring member 15b of a second type that is the short wiring member 15 provided at both ends of the string 10 and connected only to one solar cell 11. Among the wiring members 15b of the second type, the wiring member on the first end side and the wiring member on the second end side of the string 10 may have different lengths. Therefore, the cutting device 90 divides the wiring member into two or three types of wiring members 15.

FIG. 15 is a schematic view illustrating a step of drawing out the wiring member 15a of the first type cut and drawn by the cutting device 90 to the temporary crimping device 26. In FIG. 15(a), the feed chuck portion 92 draws out the wiring member 15 toward the temporary crimping device 26. In FIG. 15(b), the upper surface moves upward by the extension of the leg portion 111 of the backup stage 105, and the drawn wiring member 15 is fitted into the groove 106 provided on the upper surface. In this state, the restriction chuck portions 109 and 110 grip the end portion of the wiring member 15 on the cutting device 90 side. In this state, the upper teeth 96 and the lower teeth 97 of the cutting device 90 sandwich and cut the wiring member 15 in the vertical direction to form the wiring member 15a.

In FIG. 15(c), the feed chuck portion 92 further pulls the wiring member 15a, thereby alleviating the bending tendency of the wiring member 15a.

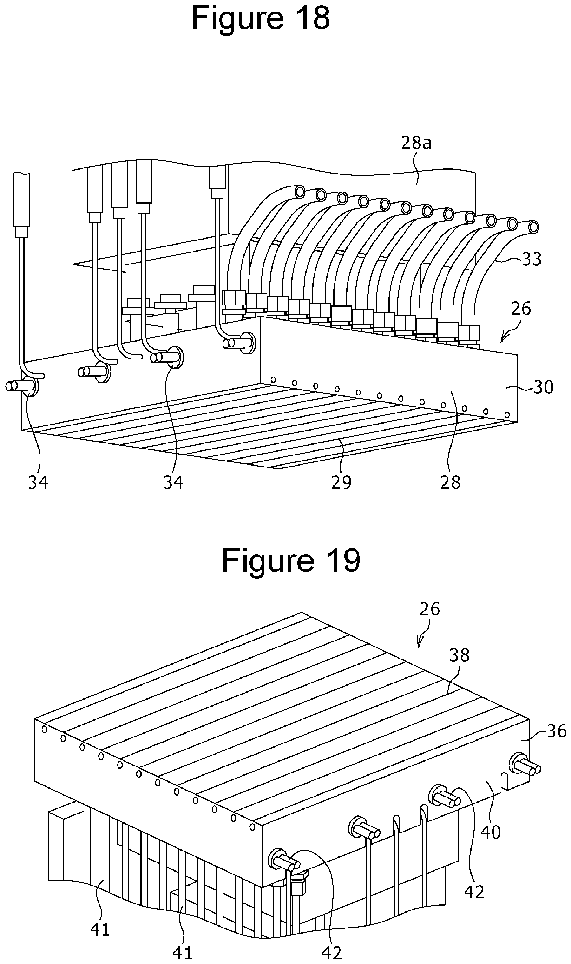

In FIG. 15(d), the rear side portion (the right side portion in FIG. 15(d)) of the wiring member 15a is sucked and held by the groove 106 of the backup stage 105 at the same height position as the upper end of the lower chuck 94 of the feed chuck portion 92. In this state, the upper chuck 93 of the feed chuck portion 92 is moved to the front side (the left side in FIG. 15(d)) with respect to the lower chuck 94 so as to be separated from the wiring member 15a. Thereafter, the upper stage 28 of the temporary crimping device 26 is lowered, the front side portion (the left side portion in FIG. 15(d)) of the wiring member 15a is fitted into suction grooves 29 (FIG. 18) provided on the lower surface of the upper stage 28, and the wiring member 15 is sucked and held in the suction groove 29. Details of the suction operation of the upper stage 28 is described below. The upper chuck 93 is moved to the front side to prevent the upper chuck 93 from interfering with the upper stage 28. As a result, the wiring member 15a is delivered from the feed chuck portion 92 to the upper stage 28.

Then, the upper stage 28 and the backup stage 105 are simultaneously lowered by the control of the control device. As a result, the wiring member 15a is moved to a predetermined arrangement position in the vertical direction.

FIG. 16 is a schematic view illustrating a step of drawing out the wiring member 15b of the second type cut and drawn by the cutting device 90 to the temporary crimping device 26. The operation of FIG. 16(a) is similar to the operation of FIG. 15(a). At this time, unlike the case of FIG. 15(b), in a state where the feed chuck portion 92 draws out the wiring member 15 with a drawing out length which is shorter than the case of FIG. 15(b), the upper surface of the backup stage 105 moves upward due to the extension of the leg portion of the backup stage 105, and the drawn out wiring member 15 is fitted into the groove 106 provided on the upper surface. In this state, the restriction chuck portions 109 and 110 grip the end portion of the wiring member 15 on the cutting device 90 side. In this state, the upper teeth 96 and the lower teeth 97 of the cutting device 90 sandwich and cut the wiring member 15 in the vertical direction to form the wiring member 15b which is shorter than that in FIG. 15(b). In FIG. 16(b), after the upper surface of the lower stage 36 is moved upward by the extension of a leg portion 37 of the lower stage 36 of the temporary crimping device 26, the feed chuck portion 92 causes the drawn wiring member 15b to pass between the upper stage and the lower stage of the temporary crimping device 26 and to be fitted into a suction groove 38 (FIG. 19) provided on the upper surface of the lower stage 36. In this state, a restriction chuck portion 36a provided at the rear end portion (right end portion in FIG. 16) of the lower stage 36 grips the end portion of the wiring member 15b on the cutting device 90 side. The configuration and operation of the restriction chuck portion 36a are similar to those of the restriction chuck portions 109 and 110 provided on the backup stage 105.

In FIG. 16(c), the feed chuck portion 92 further pulls the wiring member 15b, thereby alleviating the bending tendency of the wiring member 15b. In FIG. 16(d), the wiring member 15 is sucked and held in the suction groove 38 of the lower stage 36 at the same height position as the upper end of the lower chuck 94 of the feed chuck portion 92. Details of the suction operation of the lower stage 36 will be described below. In this state, the upper stage 28 of the temporary crimping device 26 is lowered, the wiring member 15b is fitted into the suction grooves 29 provided in the lower surface of the upper stage 28, and the wiring member 15b is sucked and held in the suction grooves 29. As a result, the wiring member 15b is delivered from the feed chuck portion 92 to the upper stage 28.

Then, the upper stage 28 is moved up and down under the control of the control device. As a result, the wiring member 15b is moved to a predetermined arrangement position in the vertical direction.

Next, a configuration for conveying the wiring member 15 of the temporary crimping device 26 will be described. Hereinafter, the wiring members 15a and 15b are collectively referred to as the wiring member 15. The string manufacturing device 25 of the embodiment achieves the object of accurately conveying the wiring member 15 and temporarily crimping the solar cell 11 in a straight line state without the tendency in the temporary crimping device 26. In addition, the embodiment also achieves the object of reducing conveyance variation when conveying a large number of the wiring members 15 to the solar cell 11 for temporary crimping, reducing the cost of the device, and improving the productivity and maintainability of the device.

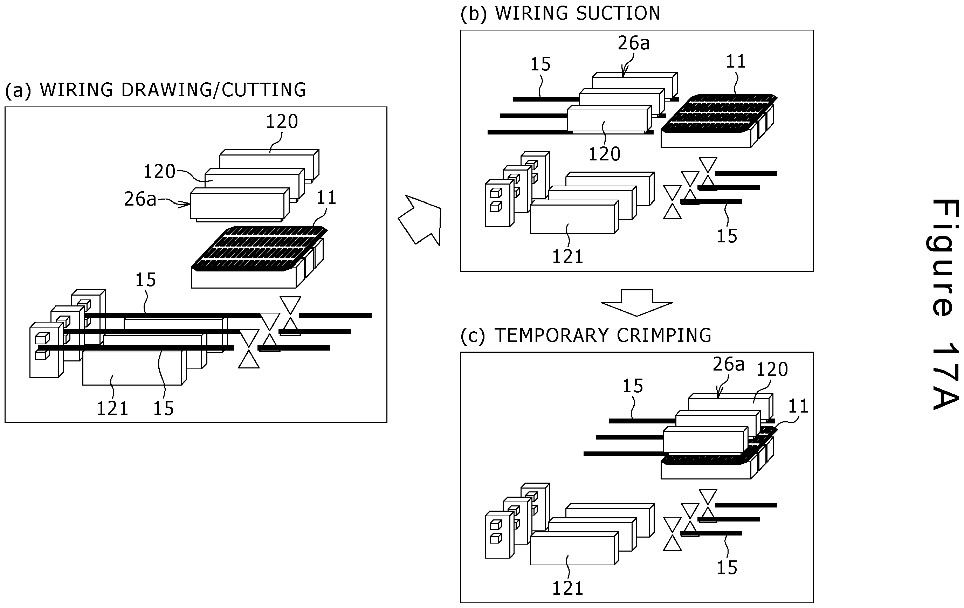

Inconvenience caused in the comparative example will be described with reference to FIG. 17A. FIG. 17A is a schematic view illustrating a step of drawing and cutting the wiring member 15 and then temporarily crimping the wiring member to the solar cell 11 in the string manufacturing device of a comparative example. In the comparative example of FIG. 17A, one suction crimping tool 120 is provided for conveying one wiring member 15, and one wiring installation base 121 is provided for arranging one wiring member 15. Therefore, in order to arrange the plurality of wiring members 15 on each of both surfaces of the solar cell 11, a temporary crimping device 26a of the comparative example includes a plurality of wiring installation bases 121 and a plurality of suction crimping tools 120. The plurality of suction crimping tools 120 suck and hold the wiring member 15 by providing suction holes for sucking outside air on the lower surface. In the temporary crimping device 26a, one wiring member 15 drawn out from the wiring member winding portion and cut is arranged on each of the upper surfaces of the plurality of wiring installation bases 121 in a wiring drawing and cutting step illustrated in (a) of FIG. 17A.

Then, in a wiring suction step illustrated in (b) of FIG. 17A, the suction crimping tools 120 are brought close to each of the plurality of wiring installation bases 121 one by one, and the wiring members 15 are sucked and held on the lower surfaces of the suction crimping tools 120 and then moved upward and in the lateral direction to the upper side of the solar cell 11. Then, in the wiring member temporary crimping step illustrated in (c) of FIG. 17A, the plurality of suction crimping tools 120 are lowered, and the wiring members 15 are pressed against the position where the adhesive has been applied on the upper surface of the solar cell 11, thereby temporarily crimping the wiring members 15 to the solar cell 11.

In such a comparative example, a mechanism for simultaneously operating the plurality of suction crimping tools 120 is complicated, and the cost of the device increases. In addition, since the number of the suction crimping tools 120 increases, there is inconvenience in that productivity and maintainability are poor. Further, when the plurality of wiring members 15 are conveyed, there is also inconvenience in that conveyance variation is likely to occur due to a manufacturing error, an assembly error, and the like. In addition, since the wiring member 15 has a bending tendency even immediately after being linearly stretched, there is also inconvenience in that it is difficult to accurately convey the wiring member 15 to a predetermined arrangement position.

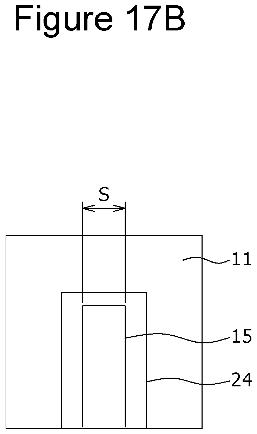

FIG. 17B is an enlarged view of a portion A in FIG. 2. As illustrated in FIG. 17B, when the wiring member 15 is connected to the solar cell 11, it is necessary to accurately arrange the wiring member 15 on the adhesive 24 applied to the solar cell 11. For example, in some cases, the wiring member 15 is required to be arranged in a range S within 0.2 mm with respect to a deviation in the lateral direction with respect to the reference position on the solar cell 11 to which the adhesive 24 is applied. At this time, when the wiring member 15 is sucked by the suction crimping tool 120 as in the comparative example, if the suction hole is small, and the suction flow rate is small, the wiring member 15 cannot be held with sufficient holding strength. Meanwhile, when the diameter of the suction hole is increased in order to increase the suction flow rate, it is likely that the adhesive will also be sucked in and the suction hole will become clogged. The temporary crimping device 26 provided in the string manufacturing device 25 of the embodiment solves such an inconvenience. The temporary crimping device 26 corresponds to a wiring member holding device.

The upper stage 28 and the lower stage 36 of the temporary crimping device 26 will be described in detail with reference to FIGS. 18 to 32. Each of the upper and lower stages 28 and 36 corresponds to a holder. FIG. 18 is a schematic perspective view illustrating the upper stage 28 for configuring the temporary crimping device 26.

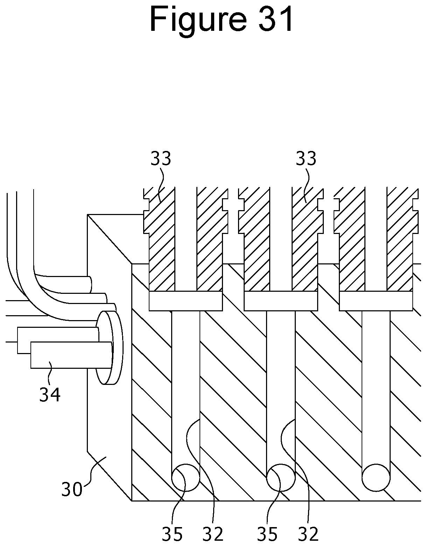

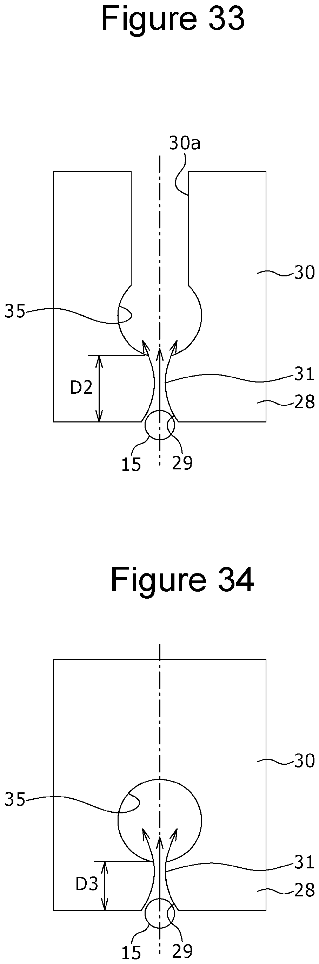

As illustrated in FIG. 18, the upper stage 28 has an upper plate 30 at the lower end portion, and the upper plate 30 is suspended and supported by a moving mechanism 28a provided on the upper side so as to be movable in the vertical direction and the lateral direction with respect to a fixing unit 130 (FIG. 5). The upper plate 30 has a substantially rectangular plate shape with a relatively large thickness and has a plurality of rows of suction grooves 29 arranged in the lateral direction on the lower surface, and extending in the front-rear direction. Hereinafter, an outgoing side of the wiring member 15 is referred to as a front side, and the opposite side is referred to as a rear side. The number of the suction grooves 29 is the same as the number of the wiring members 15 to be conveyed. The suction groove 29 has a substantially V-shaped cross section as described below, and suction holes 31 (FIGS. 33 and 34) are formed at a plurality of positions in the longitudinal direction of the bottom portion. Each of the suction holes 31 communicates with a suction passage 32 (FIG. 31) formed inside the upper plate 30. In the suction holes 31, the suction holes 31 connected to the same suction groove 29 are connected to the same suction passage 32, and the suction holes 31 connected to different suction grooves 29 are connected to different suction passages 32. Each of the plurality of suction passages 32 is connected to a vacuum pump (not illustrated) provided outside through a vacuum pipe 33 connected to an upper portion of the upper plate 30. The different suction passages 32 are connected to the different vacuum pipes 33. The outside air is sucked into the suction groove 29 by the operation of the vacuum pump, whereby the wiring member 15 fitted into the suction groove 29 can be sucked and held. The vacuum pump corresponds to a suction device that sucks outside air. Therefore, the upper stage 28 sucks and holds the wiring member 15 on the lower surface, which is the surface on the suction side, using the vacuum pump. The suction groove 29 of the upper stage 28 is formed along the longitudinal direction of the wiring member 15, and the suction hole 31 communicating with the vacuum pump side is formed at the bottom portion.

Further, a plurality of heaters 34 that generate heat by energization are inserted into upper plate 30 in the lateral direction. As a result, the upper plate 30 can heat the wiring member 15 held in the suction groove 29 and press the wiring member 15 against the solar cell 11. A thermocouple (not illustrated) is also inserted into the inside of the upper plate 30, so that the temperature of the upper plate 30 can be detected. The detection signal of the thermocouple is output to the control device, and the control device controls the operation of the heater 34. Thus, the temperature of upper plate 30 can be controlled. Since the suction grooves 29 corresponding to the number of the wiring members 15 are provided in the upper plate 30, the temperature distribution becomes better than the case where the wiring members 15 are individually heated. In addition, the heater 34 and the control configuration thereof can be simplified. Furthermore, since the wiring member 15 is sucked and held in a state of being fitted into the suction groove 29 on the lower surface of the upper plate 30, lateral deviation of the wiring member 15 can be prevented, and the plurality of wiring members 15 can be held in a state in which the vertical positions are aligned. As a result, when the plurality of wiring members 15 are pressed against the upper surface of the solar cell 11, cracking of the solar cell 11 can be prevented. In addition, since the plurality of wiring members 15 are collectively sucked and conveyed by the upper plate 30, and crimping to the solar cell 11 can be performed collectively, the number of suction crimping tools 120 corresponding to the respective wiring members 15 increases as in the comparative example of FIG. 17A, and it is not necessary to adjust the tool heights. In addition, since the plurality of wiring members 15 can be simultaneously arranged on the upper plate 30, the productivity of the string 10 is improved. Further, since the plurality of vacuum pipes 33 corresponding to the number of the plurality of suction grooves 29 are connected to the upper plate 30, it is possible to suppress the dropping of the wiring member 15 due to a decrease in the flow rate of suction in the plurality of suction holes 31.

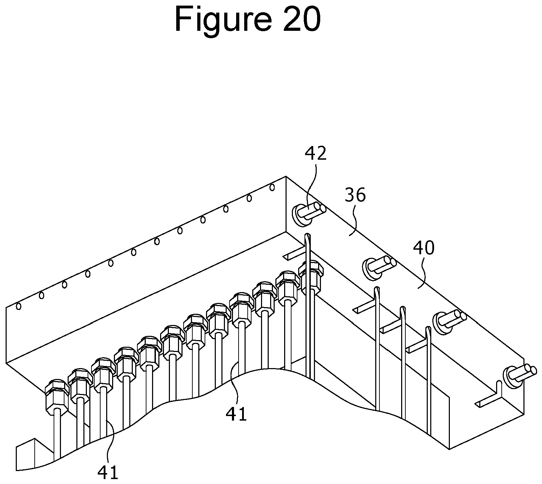

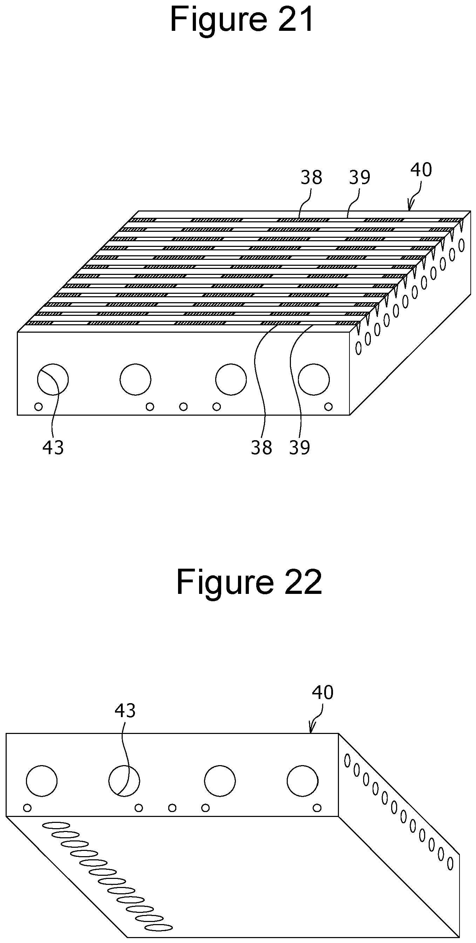

FIG. 19 is a schematic perspective view illustrating the lower stage 36 for configuring the temporary crimping device 26 as viewed from the above. FIG. 20 is a schematic perspective view illustrating the lower stage 36 as viewed from below. FIG. 21 is a schematic enlarged perspective view illustrating a lower plate 40 of the lower stage 36 as viewed obliquely from above. FIG. 22 is a schematic perspective view illustrating the lower plate 40 as viewed obliquely from below.

The lower stage 36 has the lower plate 40 at the upper end portion, and a portion including the lower plate 40 is configured to be movable in the vertical direction by a moving mechanism provided on the lower side. For example, as illustrated in FIG. 16, the moving mechanism has the extendable and contractible leg portions 37 provided at the lower end portion, and extension and contraction of the leg portions 37 are controlled by a control device. For example, the moving mechanism includes a cylinder device such as a pneumatic cylinder device or a hydraulic cylinder device. The lower plate 40 has a substantially rectangular plate shape with a relatively large thickness and has a plurality of rows of suction grooves 38 arranged in the lateral direction on the upper surface, and extending in the front-rear direction. The number of the suction grooves 38 is the same as the number of the wiring members 15 to be conveyed. The suction groove 38 has a substantially V-shaped cross section, and suction holes 39 are formed at a plurality of positions in the longitudinal direction of the bottom portion. In FIG. 21, the suction hole 39 is schematically illustrated by plain portions at a plurality of positions of the suction grooves 38. Each of the suction holes 39 communicates with a suction passage formed inside the lower plate 40. In the suction holes 39, the suction holes 39 connected to the same suction groove 38 are connected to the same suction passage, and the suction holes 39 connected to different suction grooves 38 are connected to different suction passages. Each of the plurality of suction passages is connected to a vacuum pump (not illustrated) provided outside through a vacuum pipe 41 connected to a lower portion of the lower plate 40. The different suction passages are connected to the different vacuum pipes 41. The outside air is sucked into the suction groove 38 by the operation of the vacuum pump, whereby the wiring member 15 fitted into the suction groove 38 can be sucked and held. Therefore, the lower stage 36 sucks and holds the wiring member 15 on the upper surface, which is the surface on the suction side, using the vacuum pump. The suction groove 38 of the lower stage 36 is formed along the longitudinal direction of the wiring member 15, and the suction hole 39 communicating with the vacuum pump side is formed at the bottom portion.

Similarly to the upper plate 30, a plurality of heaters 42 and thermocouples (not illustrated) are also inserted into the lower plate 40. As a result, the lower plate 40 can heat the wiring member 15 held in the suction groove 29 and press the wiring member 15 against the solar cell 11. In FIGS. 21 and 22, heater holes 43 for inserting the heaters 42 formed in the lower plate 40 are illustrated, and the heater 42 is not illustrated. The temperature of the lower plate 40 can be controlled. Since the suction grooves 38 corresponding to the number of the wiring members 15 are provided in the lower plate 40, the temperature distribution becomes better than the case where the wiring members 15 are individually heated. In addition, the heater 42 and the control configuration thereof can be simplified. Furthermore, since the wiring member 15 is sucked and held in a state of being fitted into the suction groove 38 on the upper surface of the lower plate, lateral deviation of the wiring member 15 can be prevented. As a result, when the plurality of wiring members 15 are pressed against the upper surface of the solar cell 11, cracking of the solar cell 11 can be prevented. In addition, since the plurality of wiring members 15 are collectively sucked by the lower plate 40, and crimping to the solar cell 11 can be performed collectively, the number of wiring installation bases 121 corresponding to the respective wiring members 15 increases as in the comparative example of FIG. 17A, and it is not necessary to adjust the base heights. In addition, since the plurality of wiring members 15 can be simultaneously arranged on the lower plate 40, the productivity of the string 10 is improved.

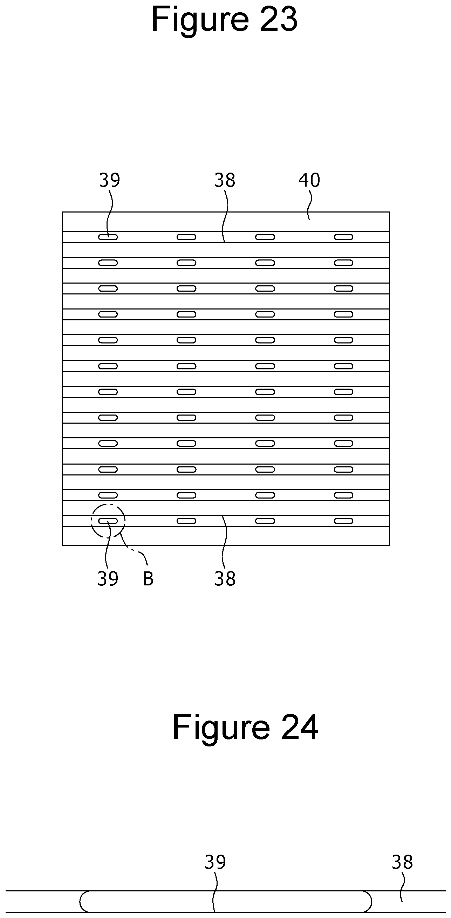

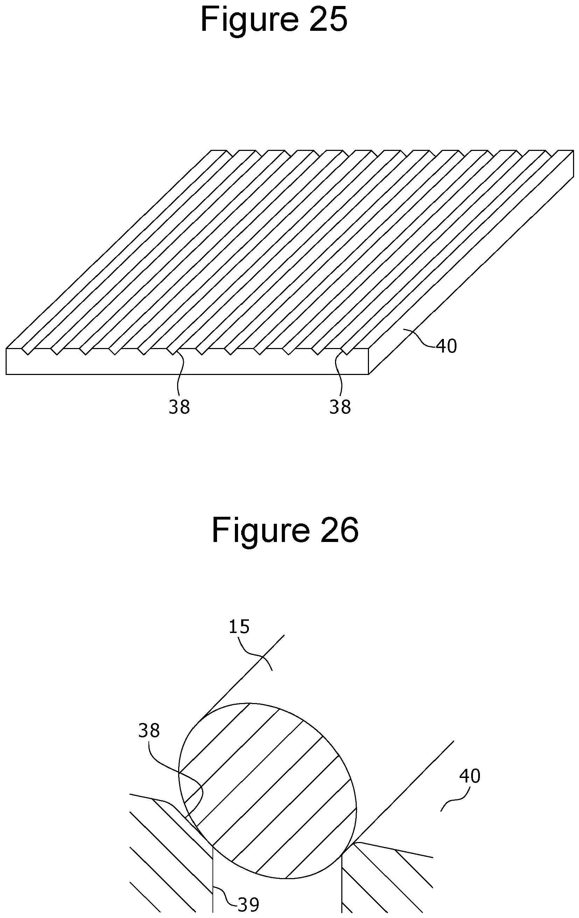

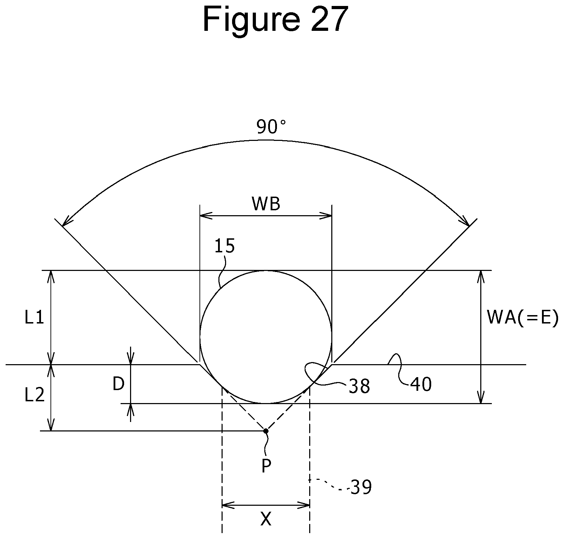

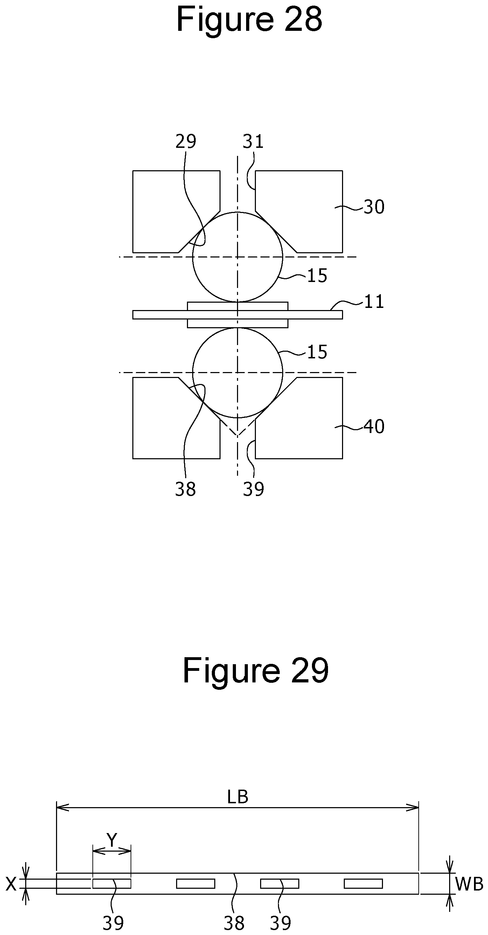

Next, the suction groove 38 of the lower plate 40 will be described more specifically. FIG. 23 is a top view of the lower plate 40. FIG. 24 is an enlarged view of a portion B in FIG. 23. FIG. 25 is a schematic perspective view illustrating the upper portion of the lower plate 40 in FIG. 21 as viewed from one end side in the longitudinal direction of the suction groove 38. FIG. 26 is an enlarged view illustrating a cross section of the lower plate 40 at a position of the suction hole 39 in a state where the wiring member 15 is sucked and held in the suction groove 38. FIG. 27 is a view illustrating a state where the wiring member 15 is arranged in one suction groove 38 in FIG. 25 as viewed from one side in the longitudinal direction. FIG. 28 is a partially enlarged cross-sectional view illustrating a state in which the wiring member 15 and the solar cell 11 are sandwiched between the upper plate 30 and the lower plate 40 during temporary crimping.

As illustrated in FIG. 23, both ends of the suction groove 38 reach both ends of the lower plate 40 in the front-rear direction. In one suction groove 38, greater than or equal to three, and less than or equal to five, suction holes 39 can be provided apart from each other in the front-rear direction. In FIG. 23, four suction holes 39 are provided in one suction groove 38. The number of suction holes 39 may be one, two, six, or more. A shape of the suction hole 39 when viewed in the thickness direction of lower plate 40 is, for example, an oval shape as illustrated in FIG. 24.

As illustrated in FIGS. 26 and 27, since the suction groove 38 has a V-shaped cross section in a state where the wiring member 15 is held in the suction groove 38, it is easy to automatically restrict the position so that the wiring member 15 is positioned at the center of the suction groove 38 in the width direction. Furthermore, since the wiring member 15 is sucked into the suction groove 38 by suction of outside air, even when the wiring member 15 has a bending tendency, it is easy to automatically restrict the position of the wiring member 15 linearly along the groove width center, so that the bending tendency is easily corrected automatically. For this reason, when the wiring member 15 and the solar cell 11 are sandwiched and pressed between the upper plate 30 and the lower plate 40 at the time of temporary crimping as illustrated in FIG. 28, the positions of the wiring members 15 in the lateral direction (left-right direction of FIG. 28) on both sides with the solar cell 11 sandwiched therebetween can be easily matched. Therefore, the wiring member 15 is easily temporarily crimped to the solar cell 11 at an appropriate position, and also, a force is prevented from being applied from the wiring member 15 to the solar cell in a direction inclined with respect to a thickness direction, so that the solar cell 11 can be effectively prevented from cracking.

As illustrated in FIG. 27, the relationship between a width X of the suction hole 39 in the lateral direction and a wiring width WA of the wiring member 15 is WA ≥ X. The wiring width WA coincides with a diameter E when the wiring member 15 has a circular cross section. When the wiring member 15 is substantially rectangular, the wiring width WA is the width of the wiring member 15 in the lateral direction. As a result, unlike the case where the width X of the suction hole 39 is larger than the wiring width WA of the wiring member 15, it is possible to prevent the width of the suction groove 38 from becoming too wide, so that it is possible to prevent the adhesive from being clogged in the suction hole 39 as a result of sucking the adhesive from the solar cell 11 side. In addition, since it is possible to suppress an increase in the width of the suction groove 38, it is possible to prevent the wiring member 15 from coming into contact with a portion of the bottom portion of the suction groove 38 deviated from the suction hole 39, and to prevent a decrease in the suction force of the wiring member 15.

In addition, it is more preferable to restrict the width X of the suction hole 39 in the lateral direction and the wiring width WA of the wiring member 15 so as to satisfy the relationship of WA ≥ X ≥ WA × 0.6. According to this configuration, since it is possible to prevent the width X of the suction hole 39 from becoming too small with respect to the wiring member 15, it is possible to more effectively prevent the suction force of the wiring member 15 using the suction hole 39 from decreasing.

In addition, in a case where the wiring member 15 is a wire member having a circular cross section as in the illustrated example, in a state where the lower stage 36 holds the wiring member 15 in the suction groove 38, the relationship between the diameter E of the wiring member 15 and a catching amount D of the suction groove 38 and the wiring member 15 is 0 < D ≤ 0.9 × E. As a result, since the wiring member 15 protrudes from the upper surface of the lower plate 40 of the lower stage 36 in a state where the wiring member 15 is held in the suction groove 38, cracking of the solar cell 11 can be prevented by preventing interference between the solar cell 11 and the lower plate 40 at the time of temporary crimping. At the same time, it is also possible to prevent the adhesive applied to the solar cells 11 from being transferred to the lower plate 40.

In addition, it is more preferable that the diameter E of the wiring member 15 and the allowance D of the suction groove 38 and the wiring member 15 satisfy the relationship of 0.25 × E ≤ D ≤ 0.5 × E. According to this configuration, since the protrusion amount of the wiring member 15 from the suction groove 38 can be increased, even when the force applied from the lower plate 40 to the wiring member 15 at the time of temporary crimping is increased, interference between the solar cell 11 and the wiring member 15 can be more effectively prevented, and the catching amount D of the suction groove 38 to the wiring member 15 can be prevented from decreasing, so that the holding force of the wiring member 15 can be increased.

For example, when the machining intersection of the groove widths of the suction grooves 38 is ignored, the relationship between the diameter E of the wiring member 15 and the catching amount D can be D = 0.28 × E. For example, a groove width WB of the suction groove 38 and the diameter E of the wiring member 15 can both be 0.32 mm, and the catching amount D can be 0.09 mm. In this case, a protrusion height L1 of the wiring member 15 from the suction groove 38 is 0.23 mm, and a distance L2 between an imaginary intersection P when the groove inner surface is extended inward and the upper surface of the lower plate 40 is 0.16 mm.

Although the relationship between the suction groove 38 of the lower plate 40 and the wiring member 15 is described above, the same applies to the relationship between the suction groove 29 of the upper plate 30 and the wiring member 15.

The upper and lower plates 30 and 40 are heated by the heaters 34 and 42, for example, within a range of plus or minus 15°C of 170°C.

As illustrated in FIG. 27, in the V-shaped cross-sectional shape of the suction groove 38, the angle of the groove inner surfaces on both sides in the width direction is preferably 90 degrees.

FIG. 29 is a schematic view illustrating a preferable dimensional relationship between the suction groove 38 and the suction hole 39. A length LB of the suction groove 38 and a length Y of the suction hole 39 preferably satisfy a relationship of LB ≥ Y and more preferably satisfy a relationship of LB ≥ Y ≥ 2.5 mm.

The suction flow rate per suction hole 39 is preferably 5 L/min or more. The groove width WB of the suction groove 38 and a width WA (FIG. 27) of the wiring member 15 preferably satisfy the relationship of WB ≤ WA.

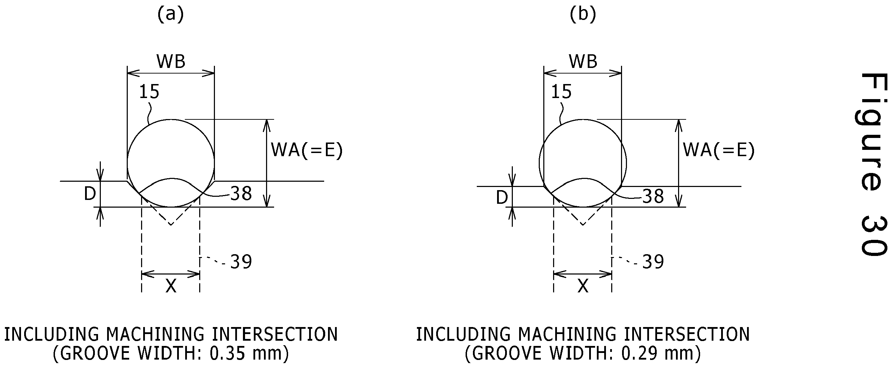

FIG. 30(a) is a diagram illustrating a case where the groove width WB has a maximum value including machining intersection, and FIG. 30(b) is a diagram illustrating a case where the groove width WB has a minimum value including machining intersection, with respect to a dimensional relationship between the suction groove 38 and the wiring member 15. As illustrated in FIG. 30(a), when the groove width WB of the suction groove 38 is the maximum value including the machining intersection (for example, when the reference value of the groove width WB is 0.32 mm and the maximum value of the machining intersection is + 0.03 mm), the groove width WB of the suction groove 38 is 0.35 mm. In this case, the relationship between the diameter E of the wiring member 15 and the catching amount D can be D = 0.34 × E. In addition, the diameter E of the wiring member 15 may be 0.32 mm, and the catching amount D may be 0.11 mm.

As illustrated in FIG. 30(b), when the groove width WB of the suction groove 38 is the minimum value including the machining intersection (for example, when the reference value of the groove width WB is 0.32 mm and the minimum value of the machining intersection is -0.03 mm), the groove width WB of the suction groove 38 is 0.29 mm. In this case, the relationship between the diameter E of the wiring member 15 and the catching amount D can be D = 0.25 × E. In addition, the diameter E of the wiring member 15 may be 0.32 mm, and the catching amount D may be 0.08 mm.

In each of the upper and lower plates 30 and 40, the plurality of suction holes 31 provided in each of the suction grooves 29 and 38 are connected to an air collection passage 35 (FIG. 31) that is long in the lateral direction as one collecting passage. At this time, a preferable value of the elongated hole depth, which is the distance between the air collection passage 35 and the opening end of the suction groove 38, is set as follows. This will be described with reference to the drawings illustrating the upper plate 30.

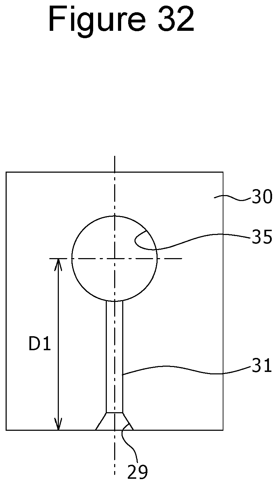

FIG. 31 is a perspective view illustrating a part of the upper plate 30 in a cut manner. FIG. 32 is a cross-sectional view illustrating a first example of a shape in which the air collection passage 35 and the suction groove 29 are communicated with each other via the suction hole 31 that is the long hole in the upper plate 30. As illustrated in FIG. 31, the plurality of suction holes 31 provided for each suction groove 29 are connected to the air collection passage 35, and the air collection passage 35 is connected to the vacuum pipe 33. At this time, with the shape of the first example illustrated in FIG. 32, a distance D1 from the center of the air collection passage 35 to the opening end of the suction groove 38 is 13 mm. In this case, since the length of the suction hole 31 communicating the air collection passage 35 and the suction groove 29 is too large, the suction force in the suction groove 29 becomes weak. In this case, it is difficult to process the suction hole 31.

Meanwhile, FIGS. 33 and 34 illustrate a case where the suction hole 31 is easily processed, and the suction force of the suction groove 29 is favorable. FIG. 33 is a cross-sectional view illustrating a second example of a shape in which the air collection passage 35 and the suction groove 38 are communicated with each other via the suction hole 31 in the upper plate 30, and FIG. 34 is a cross-sectional view illustrating a third example of the same. In the second example illustrated in FIG. 33, in the portion where the suction hole 31 is connected to the air collection passage 35, an upper surface opening hole 30a opened to the upper surface of the upper plate 30 is formed on the side opposite to the suction hole 31. In this case, since it is easy to form the suction hole 31 with a processing tool, it is easy to increase a distance D2 from the end of the air collection passage 35 to the opening end of the suction groove 38 to as long as greater than or equal to 5 and less than or equal to 6 mm, and the suction force in the suction groove 29 can be satisfactorily improved. The upper surface opening hole 30a can be closed with a closing member at the time of use, or the vacuum pipe 33 can be connected. Meanwhile, in the third example illustrated in FIG. 34, a through hole is not formed on the side opposite to the suction hole 31 in the portion where the suction hole 31 is connected to the air collection passage 35. In this case, it is more difficult to form the suction hole 31 with a processing tool than in the example of FIG. 33, a distance D3 from the end of the air collection passage 35 to the opening end of the suction groove 38 is shortened to a little less than 2 mm, and the suction force in the suction groove 29 can be satisfactorily improved. Meanwhile, in each case of FIGS. 33 and 34, from the aspect of satisfactorily improving the suction force in the suction groove 29, the distances D2 and D3 from the end of the air collection passage 35 to the opening end of the suction groove 38 may be less than or equal to 10 mm. When the distances D2 and D3 exceed 10 mm, the suction force at the opening of the suction groove 38 is considerably reduced. In addition, by performing the electrical discharge machining for a long period of time, it is possible to form the suction hole 31 such that the distances D2 and D3 become about 10 mm in both cases of FIGS. 33 and 34.

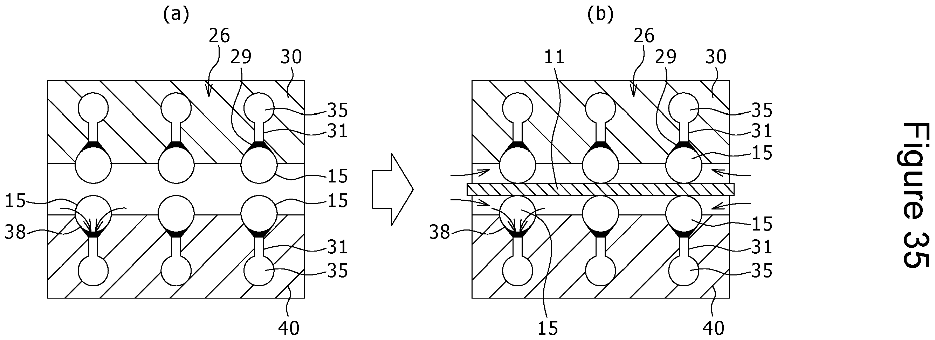

FIG. 35 is a schematic view illustrating a step of causing suction leakage in a gap between the suction grooves 29 and 38 and the wiring member 15 to fix the solar cell 11 between the wiring members 15 in a case where the wiring member 15 is temporarily crimped to the solar cell 11 after the wiring member 15 is held on the upper plate 30 and the lower plate 40 of the temporary crimping device 26 of FIG. 6. In the case of the present example, a minute gap is generated between the wiring member 15 and the suction grooves 29 and 38 at the time of temporary crimping, and leakage is caused in the air drawing flow for sucking the wiring member 15. FIG. 35(a) illustrates that air is drawn in and leaked from bottom portions of the suction grooves 29 and 38 which are painted black.

Thereafter, as illustrated in FIG. 35(b), when the solar cell 11 is sandwiched between the wiring members 15 on both sides of the upper and lower plates 30 and 40, not only can the wiring member 15 be sucked by the suction force in the suction grooves 29 and 38, but also the solar cells 11 can be sucked so as to be attracted to both the upper and lower plates 30 and 40. As a result, the wiring member 15 can be temporarily fixed to the solar cell 11 before the wiring member 15 is temporarily crimped to the solar cell 11 with the adhesive.

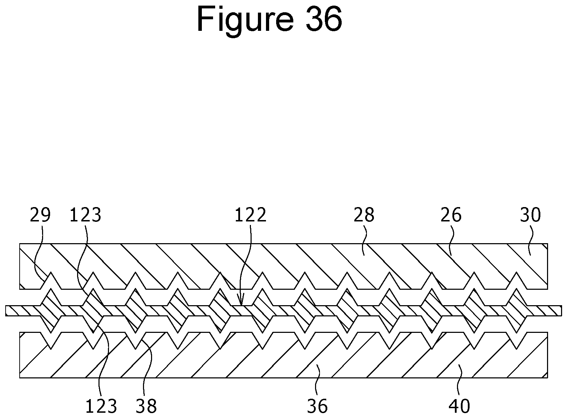

FIG. 36 is a schematic view illustrating a state in which the suction grooves 29 and 38 of the upper plate 30 and the lower plate 40 of the temporary crimping device 26 in FIG. 6 are aligned. In order for the wiring members 15 provided on both sides of the solar cell 11 to be arranged at the same position in the lateral direction (left-right direction in FIG. 36) at the time of temporary crimping and an appropriate force to be applied to the solar cell 11 from the plates 30 and 40 on the upper and lower sides via the wiring members 15, the suction grooves 29 and 38 of the upper plate 30 and the lower plate 40 need to be accurately arranged at positions facing each other. Therefore, in the present example, as illustrated in FIG. 36, in the preparation stage of both the upper and lower stages 28 and 36, an alignment jig 122 in which a plurality of protrusions 123 matching the suction grooves 29 and 38 are formed on both sides of the plate portion is used. The plates 30 and 40 are aligned such that the protrusions 123 of the alignment jig 122 are fitted into the suction grooves 29 and 38 of the plates 30 and 40 of the upper and lower stages 28 and 36. As a result, the plates 30 and 40 can be easily adjusted so as to be arranged in an appropriate positional relationship with high accuracy.

As described above, the wiring member 15 is temporarily crimped to both surfaces of the solar cell 11 by using the upper stage 28 and the lower stage 36 capable of sucking and holding the wiring member 15, the adjacent solar cell 11 and another wiring member 15 are temporarily crimped to one wiring member 15, and this is repeated, so that the temporary connection body 68 (FIG. 46) in which the plurality of solar cells 11 is temporarily connected via the wiring member 15 can be formed.

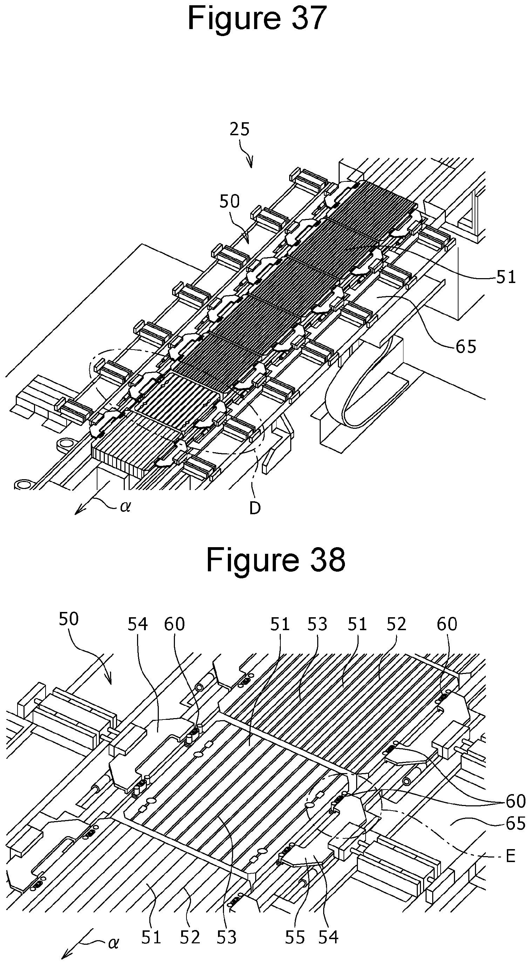

Next, the cell conveyance device used in the post-temporary crimping conveyance step will be described with reference to FIGS. 37 to 39 and the like. FIG. 37 is a perspective view illustrating the cell conveyance device 50 in the string manufacturing device 25 of FIG. 4. FIG. 38 is an enlarged view of a portion D in FIG. 37. FIG. 39 is an enlarged view of a portion E in FIG. 38.

The cell conveyance device 50 conveys the temporary connection bodies 68 of the plurality of solar cells 11 temporarily connected in a band shape by temporarily bonding the wiring members 15 from the temporary crimping device 26 to the main crimping device 70 (FIG. 5). Before describing the configuration of the cell conveyance device 50, first, problems of the comparative example will be described. FIG. 40 illustrates a state in which a temporary connection body of the solar cell 11 is conveyed in a cell conveyance device 124 of the comparative example, in which (a) is a diagram illustrating a conveyance unit of one solar cell 11 as viewed from above, and (b) is a diagram illustrating the cell conveyance device 124 as viewed in a left-right direction. The cell conveyance device 124 of the comparative example conveys the temporary connection body with a belt conveyor including two endless belts 100 arranged side by side in the left-right direction. Only three wiring members 15 are connected to both surfaces of the solar cell 11 conveyed by the cell conveyance device 124. FIG. 40(a) illustrates only a portion of the wiring member 15 in the longitudinal direction. In the solar cell 11, the belt 100 is arranged below between the two wiring members 15 so that the temporarily connected wiring members 15 do not come into contact with the belt 100. In addition, the plurality of suction holes 101 for sucking outside air are formed in the belt 100, and the suction holes 101 facing the solar cells 11 can suck and hold the solar cells 11. In the comparative example, the temporary connection body can be conveyed by driving the belt 100.

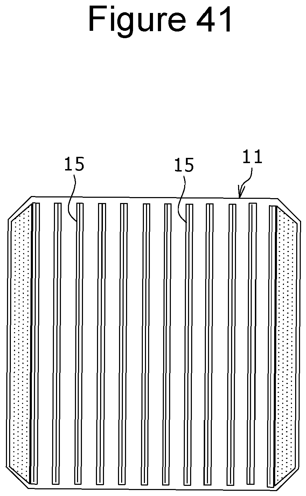

On the other hand, in the embodiment, as illustrated in FIG. 41, a large number, for example, about 12, wiring members 15 are connected to both surfaces of the solar cell 11. Therefore, it is not possible to bring the belt 100 of the belt conveyor as in the comparative example into contact with the inner portion that enters further inward than the outer periphery of the solar cell 11 as in the comparative example. In other words, the portion capable of gripping the solar cell 11 as illustrated in FIG. 41 is limited to both end portions in the left-right direction indicated by sand pattern in FIG. 41. In addition, in the temporary connection body, since the bonding strength between the wiring member 15 and the solar cell 11 is low, a large load cannot be applied to the wiring member 15.

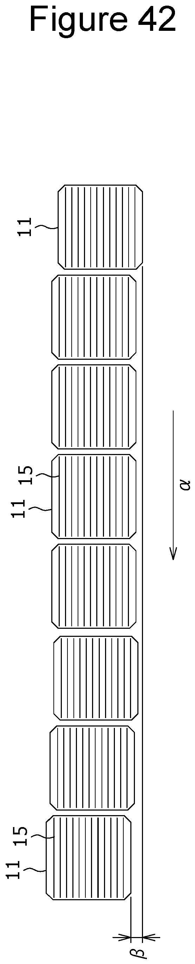

FIG. 42 is a schematic view illustrating an allowable deviation width in a case where one solar cell 11 is deviated in the left-right direction during conveyance in the temporary connection bodies of solar cells 11 by using the plurality of solar cells 11. When the temporary connection body is conveyed in the direction indicated by an arrow α in FIG. 42, it is required to suppress an allowable deviation width of the solar cell 11 to β in order to convey the temporary connection body while preventing a large load from being applied to the wiring member 15 toward the main crimping device 70 (FIG. 5). β is, for example, 1 mm. At this time, it can be said that the straightness of the temporary connection body is 1 mm. When such high straightness is required, it may be difficult to realize the requirement in the conveyance using the belt conveyor as in the comparative example. In the embodiment, the cell conveyance device 50 (FIGS. 37 to 39) described below is used in order to eliminate such inconvenience of the comparative example.

As illustrated in FIG. 37, the cell conveyance device 50 includes a plurality of cell installation bases 51, a plurality of suction holding units 60 provided on both sides in the left-right direction orthogonal to the traveling direction of each of the plurality of cell installation bases 51, and a moving mechanism 65. The plurality of cell installation bases 51 are arranged on the lower side of the temporary connection body 68 along the traveling direction of the temporary connection body 68 (FIG. 46). Similarly to the lower plate 40 of the temporary crimping device 26, in the plurality of cell installation bases 51, a plurality of suction grooves 52 capable of sucking and holding the plurality of wiring members 15 are formed on the upper surface. In some of the cell installation bases 51, the suction grooves 52 are not illustrated. An air relief groove 53 is formed between the adjacent suction grooves 52 on the upper surface of the cell installation base 51. In some of the cell installation bases 51, the relief grooves 53 are not illustrated. Both ends of the relief groove 53 in the longitudinal direction reach both ends of the cell installation base 51 in the front-rear direction. Hereinafter, the front side in the traveling direction (the direction of the arrow α in FIGS. 37 and 38) of the temporary connection body 68 may be referred to as "front", and the rear side in the traveling direction may be referred to as "rear". This makes it possible to prevent slippage of the solar cell 11 in a state where the solar cell 11 is arranged on the upper surface of the cell installation base 51 as described below. The depth of the relief groove 53 is made sufficiently deeper than that of the suction groove 38.

As illustrated in FIG. 38, a total of four suction holding units 60, that is, two on the front side and two on the rear side, are provided on both sides of one cell installation base 51 in the left-right direction orthogonal to the front-rear direction. Restriction guides 54 having substantially U-shaped arms 55 in top view are provided on both sides of the cell installation base 51 in the left-right direction. The distal end of the arm 55 of each restriction guide 54 faces the cell installation base 51. The restriction guide 54 is configured such that the arm 55 is fixed to a distal end portion of a rod that can be expanded and contracted in the left-right direction by a cylinder device such as a hydraulic cylinder. The operation of the cylinder device is controlled by the control device. By arranging the temporary connection body 68 on the upper surfaces of the plurality of cell installation bases 51 and moving the temporary connection body 68 to the front side in the traveling direction in a state where the distal end position of each arm 55 is arranged at an appropriate position, it is possible to guide the temporary connection body 68 with the distal end of the arm 55 and improve the straightness.

The suction holding units 60 are arranged one by one so as to face the distal ends of the respective arms 55 of the restriction guide 54. As illustrated in FIG. 39, the suction holding unit 60 includes a suction pad 61 of which upper end is opened and two support pins 62 provided on both sides of the suction pad 61 in the front-rear direction and protruding upward. At least an upper end portion of the suction pad 61 is made of rubber, and an inside thereof is connected to a vacuum pump (not illustrated). The vacuum pump is controlled by the control device. The suction pad 61 sucks outside air from above by an operation of the vacuum pump. Thus, the four suction pads 61 can suck and hold four positions on the lower surface of both end portions of the solar cell 11 in the left-right direction. As a result, the plurality of suction holding units 60 are pressed against the lower surfaces of the both end portions of the plurality of solar cells 11 in the left-right direction, and suck and hold both end portions of the plurality of solar cells 11 in the left-right direction by sucking outside air to the lower side.

The upper end opening edge of the suction pad 61 is slightly bent downward in a state where the solar cell 11 is sucked by the suction pad 61, but in this state, the upper end of the suction pad 61 and the upper end of the support pin 62 are at the same position in the vertical direction. As a result, it is possible to suppress the downward warpage when both end portions of the solar cell 11 in the left-right direction are sucked by the support pins 62.

The cell conveyance device 50 collectively conveys the plurality of solar cells 11 by pole feeding. For this purpose, the cell conveyance device 50 includes a moving mechanism 65 that moves the plurality of suction holding units 60 to both sides in the vertical direction and the traveling direction (the directions of the arrows α in FIGS. 37 and 38). The operation of the moving mechanism 65 is controlled by the control device. In the cell conveyance device 50, each of the plurality of suction holding units 60 sucks and holds both end portions of the plurality of solar cells 11 of the temporary connection bodies 68 in the left-right direction (the both end portions in the left-right direction in FIG. 41) and then moves upward and to the front side in the traveling direction. Thereafter, the plurality of suction holding units 60 move downward to move the temporary connection body 68 from the cell installation base 51 to the cell installation base 51 on the front side in the traveling direction and stop suction. Thereafter, the plurality of suction holding units 60 return to the rear side in the traveling direction. The plurality of suction holding units 60 repeat the above operation to move the temporary connection body 68 to the front side in the traveling direction.

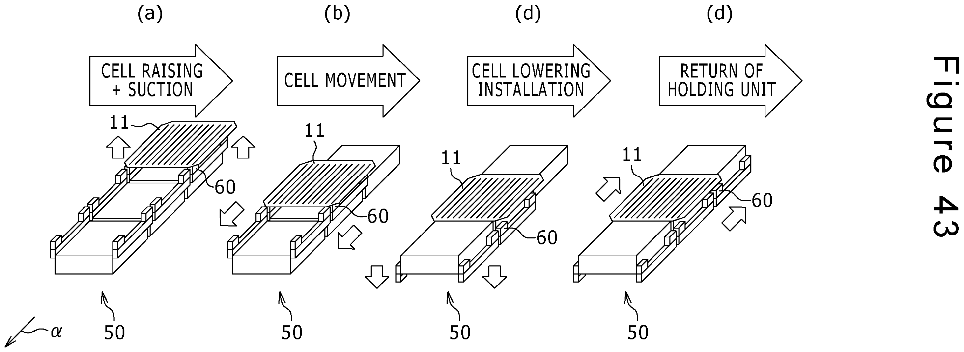

FIG. 43 is a schematic view illustrating an operation when the solar cell 11 is conveyed by using the cell conveyance device 50 in the embodiment. FIG. 43 illustrates the operation when one solar cell 11 is used instead of the temporary connection body and moved to the front side in the traveling direction (the direction of the arrow α in FIG. 43).

In FIG. 43(a), outside air is sucked in a state where the suction holding units 60 are pressed from below against both end portions of the lower surface of the solar cell 11 in the left-right direction, whereby the solar cell 11 is held by the suction holding units 60. In this state, when the suction holding unit 60 moves upward, the solar cell 11 also moves upward. Then, in FIG. 43(b), the suction holding unit 60 moves to the front side in the traveling direction by one solar cell 11. Next, in FIG. 43(c), the suction holding unit 60 and the solar cell 11 are lowered, and the solar cell 11 is arranged on the upper surface of the cell installation base 51 on the front side in the traveling direction. At this time, the suction of the suction holding unit 60 is stopped, and the suction holding unit 60 is lowered so as to be separated from the lower surface of the solar cell 11. In FIG. 43(d), the suction holding unit 60 moves to the rear side in the traveling direction to return to the position in the state before FIG. 43 (a). By repeating FIGS. 43(a) to 43(d), the solar cell 11 moves to the front side in the traveling direction. Although the conveyance operation of the solar cells 11 is described with reference to FIG. 43, the temporary connection body 68 (FIG. 46) in which the plurality of solar cells 11 is temporarily connected can be moved in the traveling direction in the same manner. Furthermore, in the present example, at this time, the plurality of suction holding units 60 can be coupled and moved in synchronization in the same direction.

With the string manufacturing device 25 including the cell conveyance device 50 as described above, even in a case where the holding unit cannot be brought into contact with an inner portion that is very deeply inside from the outer periphery of the solar cell 11 due to the large number of wiring members 15 for each solar cell 11, the temporary connection body 68 can be conveyed while preventing contact with the wiring member 15 by bringing the suction holding unit 60 into contact with both end portions of the solar cell 11 in the left-right direction. In addition, since the temporary connection body 68 can be conveyed while maintaining a change in the distance between the solar cells 11, it is possible to prevent a large load from being applied to the wiring member 15. Further, the temporary connection body 68 can be conveyed with high accuracy and straightness so that the wiring member 15 does not deviate from the bonding region in the left-right direction.

Further, in the cell conveyance device 50, since it is sufficient that both end portions of the solar cell 11 in the left-right direction can be sucked, even when the wiring pattern of the wiring member 15 in the solar cell 11 is changed, the solar cell can be conveyed by the same cell conveyance device 50.

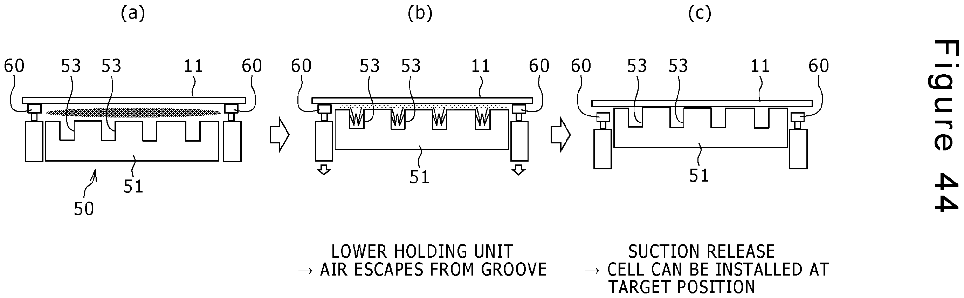

FIG. 44 is a schematic view illustrating an effect obtained by forming the relief groove 53 on the upper surface of the cell installation base 51 of the cell conveyance device 50 in the embodiment. As illustrated in FIG. 44(a), when a gap is provided between the upper surface of the cell installation base 51 and the solar cell 11, a layer of air schematically shown by an oblique lattice part exists in this gap. Then, the air between the solar cell 11 and the upper surface of the cell installation base 51 tends to be compressed by lowering the suction holding unit 60 as illustrated in FIG. 44(b), but a portion of the air enters the relief groove 53 of the cell installation base 51 and escapes in the front-rear direction, so that the air can be released. As a result, the solar cell 11 can be accurately installed at the target position on the upper surface of the cell installation base 51 in a state where the suction holding unit 60 is separated from the solar cell 11 as illustrated in FIG. 44(c).

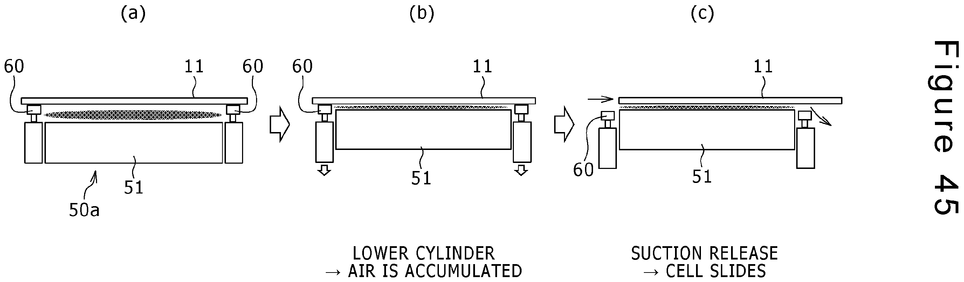

Meanwhile, FIG. 45 is a schematic view illustrating inconvenience when there is no relief groove on the upper surface of the cell installation base 51 of a cell conveyance device 50a in another example of the embodiment. In the configuration of FIG. 45, only the suction groove 52 into which the wiring member 15 is fitted is formed on the upper surface of the cell installation base 51, and the relief groove for releasing the air is not formed. In this configuration, as illustrated in FIGS. 45(a) to 45(b), when the solar cell 11 comes close to the upper surface of the cell installation base 51, the layer of air schematically illustrated in the oblique lattice portion remains accumulated. Therefore, as illustrated in FIG. 45(c), when the suction holding unit 60 is separated from the solar cell 11, the layer of air remains between the solar cell 11 and the upper surface of the cell installation base 51, and the solar cell 11 slides, so that the installation position of the solar cell 11 is likely to become unstable. According to the configuration of FIG. 44, such an inconvenience can be prevented. Although the case where the air relief grooves 53 are formed on the upper surface of the cell installation base 51 is described above, instead of the relief grooves 53, a plurality of through holes penetrating the plate on the upper surface of the cell installation base 51 in the vertical direction may be formed to be dispersed at a plurality of positions in top view.

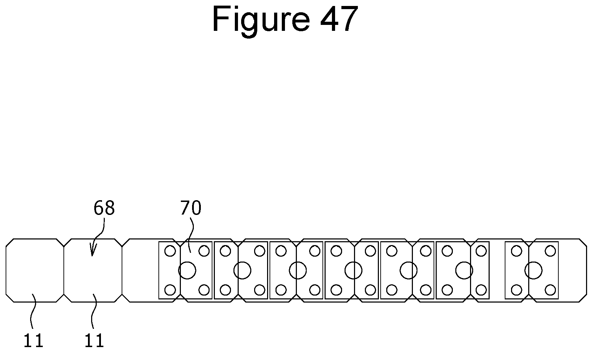

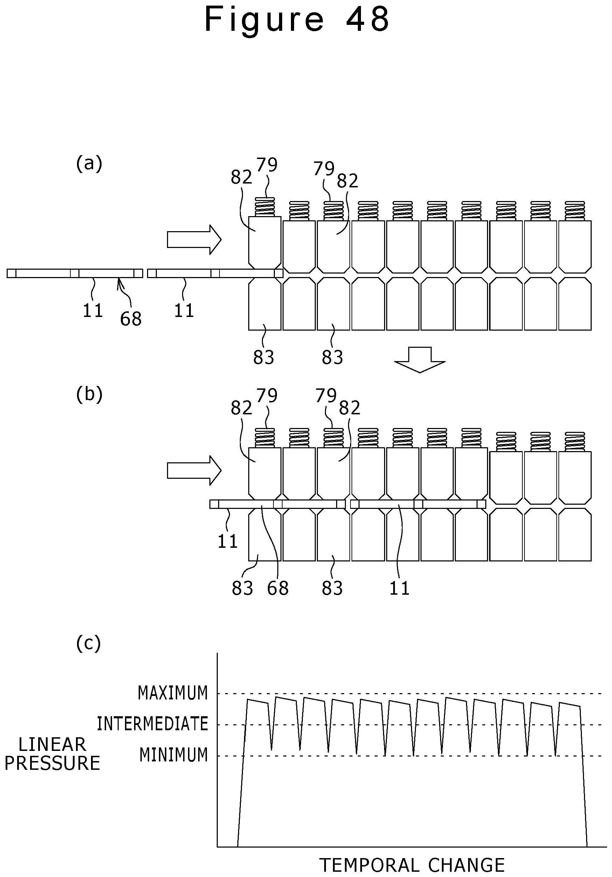

Next, the main crimping device 70 used in the wiring member main crimping step will be described with reference to FIGS. 46 to 48 and the like. FIG. 46(a) is a schematic view illustrating a state in which the temporary connection body 68 is crimped by the main crimping device 70 in the embodiment, and FIG. 46(b) is a view illustrating a temporal change in a temperature (cell temperature) of a front end portion of the temporary connection body 68 and a linear pressure applied to the front end portion of the temporary connection body 68 when the temporary connection body 68 is caused to pass through the main crimping device 70 in FIG. 46(a). FIG. 47 is a perspective view illustrating the main crimping device 70 and the temporary connection body 68 of FIG. 46(a) as viewed from above. FIGS. 48(a) and 48(b) are schematic views illustrating an operation when the temporary connection body 68 is caused to pass through the main crimping device 70 of the embodiment, and FIG. 48(c) is a view illustrating a temporal change in the linear pressure applied to the front end portion of the temporary connection body 68 when the temporary connection body 68 is caused to pass through the main crimping device 70. In FIGS. 46 to 48, wiring members connecting the adjacent solar cells 11 in the temporary connection body 68 are not illustrated.

As illustrated in FIG. 46, the main crimping device 70 conveys the temporary connection body 68 conveyed by the cell conveyance device 50 by driving both belts 71 and 72 while sandwiching the temporary connection body 68 between the upper belt 71 and the lower belt 72, and performs heating and pressurization in the vertical direction by a plurality of pressing stages 75 provided so as to sandwich the upper belt 71 and the lower belt 72 from both upper and lower sides and including a heater. Thus, in the temporary connection body 68, the adhesive 24 (FIG. 2 and the like) with the wiring member 15 (FIG. 2 and the like) temporarily bonded to the solar cell 11 is cured to form the strings 10 (FIG. 1) in which the plurality of solar cells 11 are bonded via the wiring member 15.

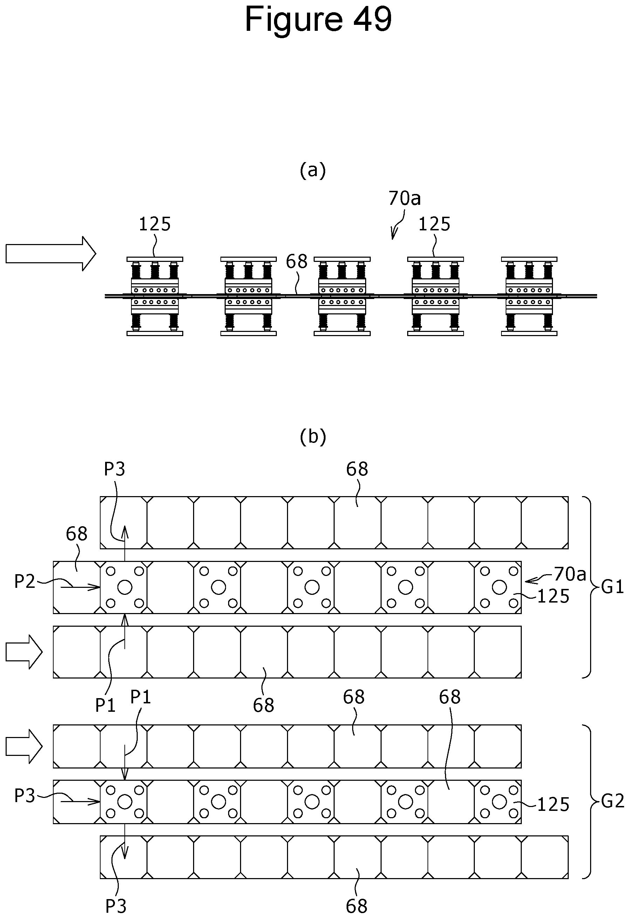

Before describing the configuration of the main crimping device 70 in detail, first, problems of the comparative example will be described. FIG. 49(a) is a side view illustrating a main crimping device 70a configuring a string manufacturing device of a first example of the comparative example, and FIG. 49(b) is a schematic view illustrating a state in which a change in a position of the temporary connection body 68 when the temporary connection body 68 is moved while being crimped by the main crimping device 70a is viewed from above.

In the main crimping device 70a of the first example of the comparative example, the heating pressing time in one heating pressing stage 125 is lengthened in order to secure a long heating time in each solar cell 11. For this reason, in the comparative example, the main crimping line is branched into two sets of lines G1 and G2 to increase the number of heating pressing stages 125. Then, while the temporary connection bodies 68 are moved in arrows P1 to P3 in the lines G1 and G2 of the first set and the second set, respectively, strings are formed and conveyed by passing the heating pressing stages 68 twice per one solar cell 11. In such a comparative example, productivity is deteriorated, and the manufacturing device is increased in size, which leads to an increase in cost. An object of the main crimping device 70 of the embodiments of FIGS. 46 to 48 is to solve such inconvenience.

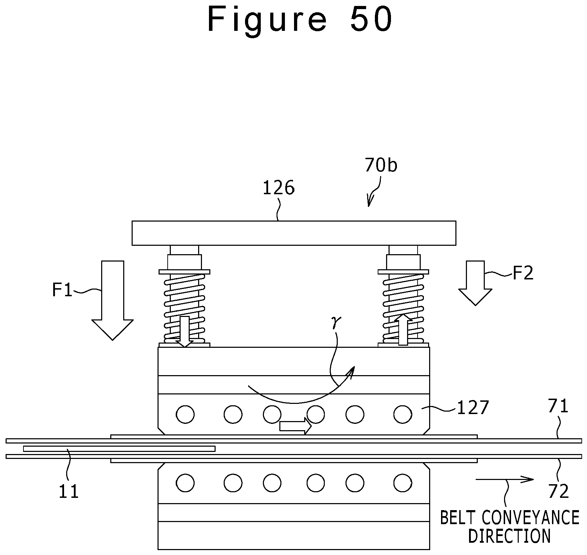

In addition, FIG. 50 is a schematic view illustrating a state in which a linear pressure is non-uniformly applied to one solar cell 11 in the main crimping device 70b configuring the string manufacturing device of a second example of the comparative example. In the main crimping device 70b of the second example of the comparative example, the temporary connection body 68 is sandwiched with a belt conveyor having the upper belt 71 and the lower belt 72, between both the belts 71 and 72, and is conveyed by driving the belts 71 and 72. At this time, due to an increase in drag resistance acting between the belts 71 and 72 and the upstream end (the left end in FIG. 50) of a heating pressing stage 126, a force is applied in a direction of rotating an upper plate 127 as indicated by an arrow γ, and a pressing force F1 on the upstream side is higher than a pressing force F2 on the downstream side. Due to the force in the direction of the arrow y, a downward force is applied to the upstream end portion of the upper plate 127, but an upward force is applied to the downstream end portion (the right end portion in FIG. 50). For this reason, at the start of pressurization of the solar cells 11, the load concentrates on the distal end portion, so that it may be difficult to increase the parallelism and flatness of both upper and lower surfaces of the string, and to increase the uniformity of heating. An object of the main crimping device 70 of the embodiments is also to solve such an inconvenience.

In order to solve the problem of the first example of the comparative example, the main crimping device 70 of the embodiment illustrated in FIGS. 46 to 48 performs conveyance while crimping the wiring member 15 to the temporary connection body 68 with the upper and lower belts 71 and 72. Specifically, the main crimping device 70 causes the upper belt 71 cyclically driven by a plurality of rollers 73 and the lower belt 72 cyclically driven by a plurality of rollers 74 to face each other in the vertical direction and includes a plurality of upper plates 76 arranged on the upper surface on the inner peripheral side of the upper belt 71 and a plurality of lower plates 77 arranged on the lower surface on the inner peripheral side of the lower belt 72. In addition, in the main crimping device 70, the pressing stages 75, 80, and 81 are formed by the upper and lower plates 76 and 77 vertically facing each other via the belts 71 and 72 interposed therebetween. The plurality of lower plates 77 are fixed to a fixing member 78, and the plurality of upper plates 30 are biased downward with respect to the fixing member 78 by springs 79.

Among the plurality of pressing stages 75, 80, and 81, the pressing stage 75 excluding the pressing stages 80 and 81 at both ends of the temporary connection body 68 in the front-rear direction is heated by a heater provided inside. For example, the upper plate 76 and the lower plate 77 of the pressing stage 75 having the heater are each heated to temperatures higher than the temperatures of the upper plate 30 and the lower plate 40 of the temporary crimping device 26, for example, greater than or equal to 200°C and less than or equal to 260°C. The upper and lower belts 71 and 72 are formed of a resin or metal. As a result, the temporary connection body 68 is conveyed by driving both the belts 71 and 72 while being sandwiched between the upper belt 71 and the lower belt 72 and is heated and pressed in the vertical direction by the plurality of upper and lower plates 76 and 77 facing each other via the belts 71 and 72. Thus, in the temporary connection body 68, the adhesive with the wiring member 15 temporarily bonded to the solar cell 11 is cured to form the string 10 in which the plurality of solar cells 11 are bonded via the wiring member 15.

With the main crimping device 70, since the heating time of the temporary connection body 68 can be adjusted by the lengths of the belts 71 and 72 and the moving speeds of the belts 71 and 72, it is not necessary to branch the line of the main crimping device 70 into two sets. Accordingly, the cost of the device can be reduced, and also the maintainability can be enhanced.

Furthermore, in the belt conveyance system, the outer end portion of the upper plate 76 configuring the pressing stages 80 and 81 at both end portions in the front-rear direction is likely to float due to the relationship of belt tension. As a result, when the pressing stage 80 at the upstream end is heated by the heater, there is a problem that the temporary connection body 68 is heated in a state of being not sufficiently pressurized and the curing of the adhesive proceeds. For this reason, in the present example, the pressing stage 80 at the upstream end is a non-heating pressing stage. The pressing stage 81 at the downstream end is a non-heating pressing stage 81 in order to prevent the temporary connection body 68 from being excessively heated. The non-heating pressing stages 80 and 81 may be actively cooled by a cooling unit.

As a result, as illustrated in FIG. 46(b), the cell temperature at the front end portion of the temporary connection body 68 can be changed as indicated by a broken line H1 or a broken line H2, and the linear pressure applied to the front end portion of the temporary connection body 68 can be changed to a solid line G or be close to the solid line G. The broken line H1 indicates a case where the temporary connection body 68 is rapidly heated by the pressing stage 75 having the heater at the position closest to the upstream end with respect to the broken line H2. Therefore, according to the present example, the cell temperature at the time of allowing the temporary connection body 68 to pass through the main crimping device 70 can be maintained substantially uniformly, and the linear pressure applied to the front end portion of the temporary connection body 68 can be brought close to being uniform during the passage of the temporary connection body 68 in the main crimping device 70.

Furthermore, as illustrated in FIG. 48, in the embodiment, a multiple head system in which the non-heating pressing stages 80 and 81 and the heating type pressing stage 75 having the heater are segmented is employed. In the multiple head system, the number of pressing heads 82 and 83 that press one solar cell 11 is one or more, and one pressing head 82 or 83 does not press two or more solar cells 11. The upper pressing head 82 is biased downward with one or more springs 79. In FIG. 46, for simplification of illustration, each of the pressing stages 75, 80, and 81 is illustrated not as a stage segmented as in FIG. 48, but in practice, each of the pressing stages 75, 80, and 81 is segmented so as to have the plurality of pressing heads 82 and 83 close to each other in the front-rear direction as in FIG. 48. As a result, as illustrated in FIG. 48(c), the linear pressure applied to the front end portion of the temporary connection body 68 can be finely changed according to the number of the pressing heads 82 and 83, and also the difference in linear pressure between immediately after the temporary connection body 68 enters the main crimping device 70 and immediately before the discharge from the main crimping device 70 can be reduced.

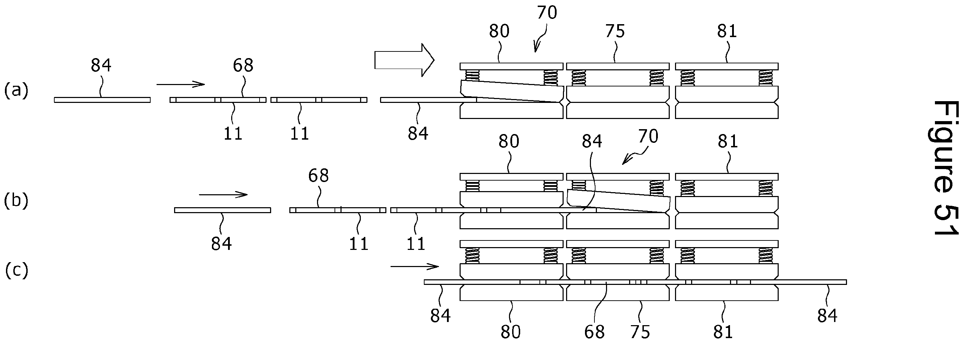

FIG. 51 is a schematic view illustrating an operation when the temporary connection body 68 and a dummy plate 84 are caused to pass through the main crimping device 70 according to the embodiment. In FIG. 51, only one heating type pressing stage 75 is illustrated for simplification. With reference to FIGS. 46 and 51, in the embodiment, when the main crimping of the temporary connection body 68 is performed, the dummy plates 84 are automatically supplied to the front side of the front end in the traveling direction of the temporary connection body 68 and the rear side of the rear end in the traveling direction of the temporary connection body 68, one by one at a distance from the temporary connection body 68. Each dummy plate 84 has a flat plate shape having substantially the same thickness as one solar cell 11. The length of the dummy plate 84 in the front-rear direction is set to be longer than the length of each of the pressing heads 82 and 83 (FIG. 48) configuring each of the pressing stages 75, 80, and 81 in the front-rear direction. Then, immediately before the temporary connection body 68 enters the pressing stage 80 at the upstream end of the main crimping device 70, the dummy plate 84 at the front end is caused to enter, and immediately before the temporary connection body 68 is discharged from the pressing stage 81 at the downstream end, the dummy plate 84 at the rear end is discharged first. In FIG. 51, the upper and lower belts are not illustrated.

The discharged dummy plate 84 may be automatically supplied to both sides of the temporary connection body 68 in the traveling direction to be mainly crimped next, and the same process may be repeated. As the dummy plate 84, one solar cell 11 to which the wiring member 15 is not connected may be used.

With the above configuration, it is possible to prevent high linear pressure from being applied from the pressing stages 80 and 81 to the front end when the temporary connection body 68 enters the main crimping device 70, and to the rear end when the temporary connection body is discharged from the main crimping device 70.

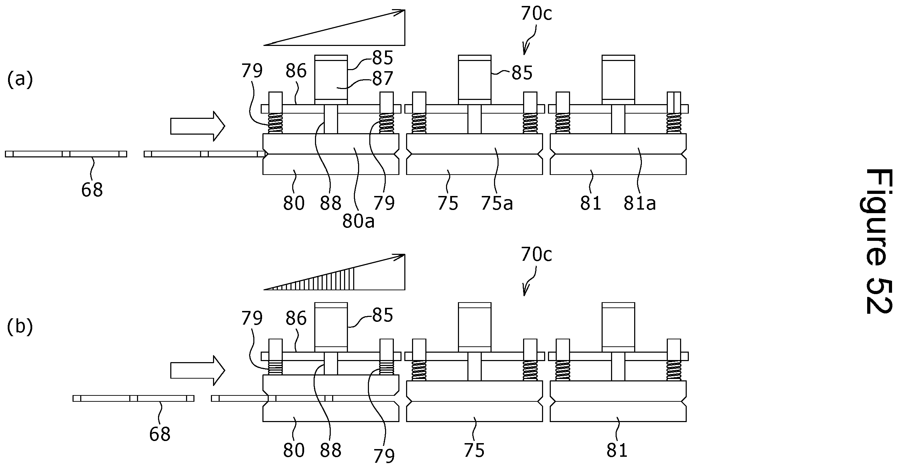

FIG. 52 is a schematic view illustrating that a variable pressure mechanism 85 is provided in each of the pressing stages 75, 80, and 81 of a main crimping device 70c to increase the pressing force of the variable pressure mechanism 85 according to the entrance of the temporary connection bodies 68 into the pressing stages 75, 80, and 81 in another example of the embodiment. In the configuration of the present example, the variable pressure mechanism 85 is provided above the pressing heads 75a, 80a, and 81a above the pressing stages 75, 80, and 81. The variable pressure mechanism 85 is provided with the springs 79 that bias downward at both ends in the front-rear direction on the upper side of each of the pressing heads 75a, 80a, and 81a, and the fixed portion of each spring 79 is supported by a support member 86. A cylinder portion of a cylinder device 87 is fixed to an intermediate portion of the support member 86 in the front-rear direction. In FIG. 52, the upper and lower belts are not illustrated. The cylinder device 87 is a pneumatic cylinder device, a hydraulic cylinder device, or the like, and an expansion and contraction amount of a rod 88 protruding downward from the cylinder portion is controlled by the control device. The lower end of the rod 88 is pressed against the upper ends of the pressing heads 75a, 80a, and 81a. As a result, since the biasing force of each spring 79 on the pressing heads 75a, 80a, and 81a changes as the expansion and contraction amount of the rod 88 changes, the pressing force and the linear pressure applied to the temporary connection body 68 by each pressing stage 75, 80, and 81 can be changed.

Then, as illustrated in FIG. 52(a), at the time when the solar cell 11 of the temporary connection body 68 is caused to enter the pressing stage 80, the minimum pressurization is applied to the front end of the solar cell 11. Next, with the entry of the temporary connection body 68, the pressing force is gradually increased in a linear manner, and when 1/2 of the length of the solar cell 11 in the front-rear direction enters the pressing stage 80 as illustrated in FIG. 52(b), 1/2 of the maximum pressing force is applied from the pressing stage 80 to the solar cell 11. When all the solar cells 11 enter the pressing stage 80, the maximum pressing force is applied from the pressing stage 80 to the solar cells 11. The same applies to a case where the solar cell 11 enters the pressing stages 75 and 81. According to the above configuration, the pressing force applied to the solar cell 11 at the time of main crimping can be made uniform. In the present example, other configurations and operations are similar to those of the embodiment described with reference to FIGS. 37 to 39, 43, 44, 46 to 48, and the like.

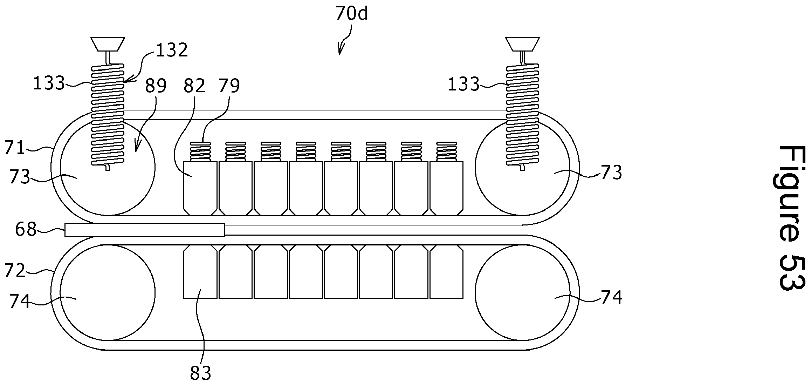

FIG. 53 is a schematic view illustrating that a self-weight canceling mechanism 132 is provided in an upper unit 89 of a main crimping device 70d in another example of the embodiment. In the configuration of the present example, the upper unit 89 includes the upper belt 71 and the two rollers 73 provided inside both front and rear ends of the upper belt 71 to circularly drive the upper belt 71. Relating to one end of each roller 73, one ends of two springs 133 for applying an upward force to the roller 73 are coupled to a fixed portion (not illustrated) fixed to the floor, and the lower end portions of two springs 133 are supported by a rotation support portion of the roller 73, and the spring 133 configures the self-weight canceling mechanism 132. The upward biasing force of the two springs 133 is set so as to cancel the downward force applied to the temporary connection body 68 by the weight of the roller 73 and the upper belt 71.

According to the above configuration, it is possible to prevent an unnecessary load from being applied to the thermocompression bonding of the temporary connection body 68 by the structure for driving the upper belt 71. Therefore, a load equalized at a low pressure can be applied to the solar cell of the temporary connection body 68 at the time of main crimping, so that it is possible to effectively prevent cracking of the solar cell which includes a semiconductor substrate such as silicon, and so that it is difficult to increase the strength. In the present example, other configurations and operations are similar to those of the embodiment described with reference to FIGS. 37 to 39, 43, 44, 46 to 48, and the like.

### REFERENCE SIGNS LIST

1 solar cell module
10 string
11 solar cell
15, 15a, 15b wiring member
25 string manufacturing device
26, 26a temporary crimping device
28 Upper stage
29 suction groove
30 upper plate
36 lower stage
38 suction groove
40 lower plate
50, 50a cell conveyance device
51 cell installation base
60 suction holding unit
65 moving mechanism
68 temporary connection body 70, 70a, 70b, 70c, 70d
main crimping device
90 cutting device

## Claims

1. A string manufacturing device for manufacturing a string by connecting a plurality of solar cells with collecting electrodes arranged side by side on a light-receiving surface and a back surface through a wiring member, the string manufacturing device comprising
a cell conveyance device that conveys a temporary connection body of the plurality of solar cells temporarily connected in a band shape by temporarily bonding the wiring member, wherein
the cell conveyance device includes: a plurality of cell installation bases arranged on a lower side of the temporary connection body along a traveling direction of the temporary connection body; a plurality of suction holding units that are provided on both sides in a left-right direction orthogonal to the traveling direction of each of the plurality of cell installation bases, are pressed against lower surfaces of both end portions of the temporary connection body in the left-right direction, and suck and hold the both end portions of the temporary connection body in the left-right direction by sucking outside air to a lower side; and a moving mechanism that moves the plurality of suction holding units to both sides in a vertical direction and the traveling direction, and
each of the plurality of suction holding units repeats an operation of sucking and holding both end portions of the temporary connection body in the left-right direction, moving upward and to the front side in the traveling direction, then moving downward to move the temporary connection body from the cell installation base to the cell installation base on the front side in the traveling direction, stopping suction, and returning to the rear side in the traveling direction, thereby moving the temporary connection body to the front side in the traveling direction.

2. The string manufacturing device according to claim 1, further comprising
a wiring member holding device that holds the wiring member, wherein
the wiring member holding device includes a holder that sucks and holds the wiring member on a surface on a suction side using a suction device that sucks outside air, and
the holder includes a suction groove formed along a longitudinal direction of the wiring member and having a bottom portion in which a suction hole communicating with the suction device side is formed, and a relationship between a width X of the suction hole and a wiring width WA of the wiring member is WA ≥ X.

3. The string manufacturing device according to claim 1, further comprising
a wiring member holding device that holds the wiring member, wherein
the wiring member holding device includes a holder that sucks and holds the wiring member on a surface on a suction side using a suction device that sucks outside air,
the wiring member is a wire member having a circular cross section,
the holder includes a suction groove formed along a longitudinal direction of the wiring member and having a bottom portion in which a suction hole communicating with the suction device side is formed, and in a state where the wiring member is held in the suction groove, a relationship between a diameter E of the wiring member and an catching amount D of the suction groove and the wiring member is 0 < D ≤ 0.9 × E.
